(19) Europäisches Patentamt
European Patent Office
Office européen des brevets

(11) EP 2 691 963 B1

(12) EUROPEAN PATENT SPECIFICATION

(45) Date of publication and mention of the grant of the patent:
**18.02.2015 Bulletin 2015/08**

(21) Application number: **12713553.1**

(22) Date of filing: **29.03.2012**

(51) Int Cl.:
***H01B 1/22*** *(2006.01)* ***H01L 29/45*** *(2006.01)*
***H01L 31/0224*** *(2006.01)* ***H05K 1/09*** *(2006.01)*

(86) International application number:
**PCT/US2012/031311**

(87) International publication number:
**WO 2012/135551 (04.10.2012 Gazette 2012/40)**

# (54) HIGH-ASPECT RATIO SCREEN PRINTABLE THICK FILM PASTE COMPOSITIONS CONTAINING WAX THIXOTROPES

WACHSTHIXOTROPE ENTHALTENDE SIEBDRUCKBARE DICKFILMPASTENZUSAMMENSETZUNGEN MIT HOHEM ASPEKTVERHÄLTNIS

COMPOSITIONS PÂTEUSES EN FILM ÉPAIS APPLICABLES PAR SÉRIGRAPHIE AYANT UN RAPPORT D'ASPECT ÉLEVÉ ET CONTENANT DES CIRES THIXOTROPES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2011 US 201161468621 P**

(43) Date of publication of application:
**05.02.2014 Bulletin 2014/06**

(73) Proprietor: **Sun Chemical Corporation**
**Parsippany, NJ 07054 (US)**

(72) Inventors:
- **MAJUMDAR, Diptarka**
**Carteret, NJ 07008 (US)**
- **KER, Hsien**
**Hasbrouck Heights, NJ 07604 (US)**
- **SCHOTTLAND, Philippe**
**Sparta, NJ 07871 (US)**
- **MCALLISTER, Michael**
**Windham, NH 03087 (US)**

(74) Representative: **Fuchs Patentanwälte Partnerschaft mbB**
**Patentanwälte**
**Westhafenplatz 1**
**60327 Frankfurt am Main (DE)**

(56) References cited:
**EP-A1- 0 527 352** **EP-A2- 0 630 031**
**WO-A1-2008/134417** **US-B2- 7 504 349**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 691 963 B1

## Description

### FIELD OF THE INVENTION

The invention relates to thick film metal pastes, such as silver pastes, that can be deposited onto a substrate using, for example, screen printing deposition to produce printed circuits, conductive lines or features on the substrate and/or a conductive surface on the front side of a solar cell device; and methods of preparing and using thick film printable metal pastes.

### BACKGROUND

The energy, electronics, and display industries rely on the coating and patterning of conductive materials to form circuits, conductive lines or features on organic and inorganic substrates. One of the primary printing methods for producing conductive patterns on organic and inorganic substrates, particularly for features larger than about 100 μm, is screen printing. Metal particles, such as silver and copper particles, are widely used in the manufacture of electrically conductive thick films for electronic devices and for other uses. Examples of thick film applications include internal electrodes in multi-layer capacitors; interconnections in multi-chip components; conductive lines in auto defoggers/deicers, photovoltaic modules, resistors, inductors, antennas; electromagnetic shielding (such as in cellular telephones), thermally conductive films; light reflecting films; and conducting adhesives.

The use of thick film conductors in electronic components is well known in the electronic field. WO 2008/134417 discloses thick film paste compositions used for solar cells. Thick film conductors can contain a dispersion of finely divided particles of a metal, including a noble metal, a metal alloy or mixtures thereof and a minor amount of inorganic binder, both dispersed in an organic medium to form a pastelike product. Such pastes are usually applied, such as by screen printing, to a substrate to form a patterned layer. The patterned thick film conductor layer then can fired to volatilize the organic medium and sinter the inorganic binder, which usually can contain glass frit or a glass-forming material. The resulting fired layer must exhibit electrical conductivity and it must adhere firmly to the substrate on which it is printed. Some of the difficulties encountered using thick film compositions known in the art include the inability to form high-aspect ratio (height: width, i.e., tall) patterns, lines or fingers; increased resistance and limited current carrying capability in fine lines or fingers; and difficulties and/or expense in forming complicated fine-line patterns.

Thus, a need exists for thick film metal pastes, particularly silver pastes, for the fabrication of conductive features to be used in electronics, displays, and other applications that result in conductive features having high aspect ratios and/or increased current carrying capability and/or decreased resistance that can be printed or patterned to form circuits, conductive lines and/or features on organic and inorganic substrates to be used in electronics, displays, and other applications efficiently and relatively inexpensively.

### SUMMARY OF THE INVENTION

Provided herein are thick film metallic paste compositions and methods for the fabrication of conductive features for use in electronics, displays, and other applications using the compositions. The thick film metallic paste compositions contain an amide wax thixotrope and can be printed or deposited to form a structure having a fine feature size, such as lines as fine as 70 μm in width, and/or to form a structure, such as a line or finger, having a high aspect ratio, such as from 0.3 to 0.45, and result in electronic features having adequate electrical and mechanical properties.

Also provided are thick film silver pastes containing a wax thixotrope and preferably having a specific range of recovery time, a specified range of shear thinning index (STI), a high aspect ratio or any combination thereof The thick film silver pastes can be formulated to have these properties by the careful selection of raw materials in combination with the thixotropic wax. A formulator will be versed in how to choose raw materials that fit the specific profiles needed to create these properties, and non-limiting examples are provided herein.

It has been found that when used for depositing or printing a feature, such as a fine line, the thick film metallic paste compositions of the present invention maintain good printability with good printed line dimension stability and high aspect ratio. The thick film metallic paste compositions of the present invention can be used on many different substrates, such as, *e.g.,* uncoated or silicon nitride (*e.g.,* $SiN_x$) coated multicrystalline or single crystalline silicon wafers and combinations thereof.

The pastes provided herein enable fine-line printing of conductor grids with high aspect ratio, which reduces the line resistivity and hence improves the performance of end-use applications, for example in solar cells. The thickness of the printed grid lines achievable by the pastes of the present invention is significantly higher than those from conventional pastes and comparable to those achieved using "hot melt" pastes or "double print" techniques, which require more complex and time consuming processes. This feature is particularly important for formulating pastes for contacting solar cells with shallow emitters, where the contact resistance is usually higher than those with a low sheet resistivity and

hence requiring low line resistivity to obtain a low overall series resistance.

## BRIEF DESCRIPTION OF THE DRAWINGS

**Figure 1** shows the shear stress recovery of Pastes 1-3 and 8 of Example 1. Recovery of paste viscosity is shown as a percentage of plateau viscosity at 0.1 $s^{-1}$ after being subjected to shear flow twice at 2 $s^{-1}$ for 3 minutes each. Each of Paste 1, Paste 2 and Paste 3 exhibits fast recovery (point of recovery less than 10 seconds), while Paste 3 exhibits slow recovery (point of recovery greater than 60 seconds). The circled areas of the graph indicate the points of recovery.

**Figure 2A** is a top view of a thick, high aspect-ratio conductor line with minimal line spreading obtained by printing Paste 8 containing a thixotropic wax.

**Figure 2B** is a cross-sectional profile of the thick, high aspect-ratio conductor line of **Figure 2A,** having a width of 84.6 $\mu$m and a height of 45.9 $\mu$m.

**Figure 3A** is a top view of a low aspect-ratio conductor line obtained by printing Paste 3, which has a low ratio of thixotropic wax to resin.

**Figure 3B** is a cross-sectional profile of the low aspect-ratio conductor line of **Figure 3A.**

**Figure 4** shows the elastic moduli of the pastes of Pastes 4 through 7 formulated with various thixotropic modifying agents. Paste 4, which contains a preferred high melting-point thixotropic modifying agent, Crayvallac Super®, maintains high elastic moduli at higher temperatures than pastes based on other thixotropic agents (Pastes 4-6).

**Figures 5A, 5B and 5C** illustrate the effect of thixotropic modifying agents, e.g., thixotropic waxes, on slumping. In **Figure 5A**, a printed line from a paste formulated with a high melting-point thixotropic wax (Paste 4) does not exhibit slumping during drying and subsequent firing. This is compared to the slump exhibited by pastes formulated with a low melting-point thixotropic wax (*e.g.*, Paste 7), which slumped significantly at fast drying rates **(Figure 5B)** as well as at slow drying rates **(Figure 5C).**

**Figure 6** shows the storage moduli (G') of the pastes of Pastes 4 through 7 formulated with various thixotropic modifying agents. Paste 4, which contains a preferred high melting-point thixotropic modifying agent, Crayvallac Super®, maintains high storage moduli at higher temperatures than pastes based on other thixotropic agents (Pastes 4-6).

## DETAILED DESCRIPTION OF THE INVENTION

It is to be understood that the foregoing general description and the following detailed description are exemplary and explanatory only and are not restrictive of any subject matter claimed.

The section headings used herein are for organizational purposes only and are not to be construed as limiting the subject matter described.

### I. Definitions

Unless defined otherwise, all technical and scientific terms used herein have the same meaning as is commonly understood by one of skill in the art to which the inventions belong. All patents, patent applications, published applications and publications, websites and other published materials referred to throughout the entire disclosure herein, unless noted otherwise, are incorporated by reference in their entirety for any purpose.

In this application, the use of the singular includes the plural unless specifically stated otherwise.

In this application, the use of "or" means "and/or" unless stated otherwise. As used herein, use of the term "including" as well as other forms, such as "includes," and "included," is not limiting.

As used herein, ranges and amounts can be expressed as "about" a particular value or range. "About" is intended to also include the exact amount. Hence "about 5 percent" means "about 5 percent" and also "5 percent." "About" means within typical experimental error for the application or purpose intended.

As used herein, "optional" or "optionally" means that the subsequently described event or circumstance does or does not occur, and that the description includes instances where said event or circumstance occurs and instances where it does not. For example, an optional component in a system means that the component may be present or may not be present in the system.

As used herein, the term "dispersant" refers to a dispersant, as that term is known in the art, that is a surface active agent added to a suspending medium to promote the distribution and separation of fine or extremely fine metal particles. Exemplary dispersants include branched and unbranched secondary alcohol ethoxylates, ethylene oxide / propylene oxide copolymers, nonylphenol ethoxylates, octylphenol ethoxylates, polyoxylated alkyl ethers, alkyl diamino

quaternary salts and alkyl polyglucosides.

As used herein, the term "surface active agent" refers to a chemical, particularly an organic chemical, that modifies the properties of a surface, particularly its interaction with a solvent and/or air. The solvent can be any fluid.

As used herein, the term "surfactant" refers to surface active molecules that absorb at a particle/solvent, particle/air, and/or air/solvent interface, substantially reducing their surface energy. The term "detergent" is often used interchangeably with the term "surfactant." Surfactants generally are classified depending on the charge of the surface active moiety, and can be categorized as cationic, anionic, nonionic and amphoteric surfactants.

As used herein, an "anti-agglomeration agent" refers to a substance, such as a polymer, that shields (*e.g.*, sterically and/or through charge effects) metal particles from each other to at least some extent and thereby substantially prevents a direct contact between individual nanoparticles thereby minimizing or preventing agglomeration.

As used herein, the term "adsorbed" includes any kind of interaction between a compound, such as a coating, a dispersant or an anti-agglomeration agent, and a metal particle surface that manifests itself in at least a weak bond between the compound and the surface of a metal particle.

As used herein, the term "particle" refers to a small mass that can be composed of any material, such as a metal, *e.g.*, conductive metals including silver, gold, copper, iron and aluminum), alumina, silica, glass or combinations thereof, such as glass-coated metal particles, and can be of any shape, including cubes, flakes, granules, cylinders, rings, rods, needles, prisms, disks, fibers, pyramids, spheres, spheroids, prolate spheroids, oblate spheroids, ellipsoids, ovoids and random non-geometric shapes. Typically the particles can have a diameter or width or length between 1 nm to 2500 nm. For example, the particles can have a diameter (width) of 1000 nm or less.

As used herein, the term "diameter" refers to a diameter, as that term is known in the art, and includes a measurement of width or length of an anisotropic particle. As used throughout the specification, unless otherwise stated, diameter refers to $D_{50}$ diameter.

As used herein, "$D_X$" where X is an integer refers to the median value of particle diameter and specifies the X percentage of particles below the recited value. For example, if X=10, and $D_{10}$=1$\mu$m, only 10% of the particles have a diameter smaller than 1$\mu$m. If X=50, and $D_{50}$=1$\mu$m, 50% of the particles have a diameter smaller than 1$\mu$m. If X=90 and $D_{90}$=1$\mu$m, 90% of the particles have a diameter smaller than 1$\mu$m.

As used herein, "adhesion" refers to the property of a surface of a material to stick or bond to the surface of another material. Adhesion can be measured, e.g., by ASTM D3359-08.

As used herein, "recovery time" refers to the time that a sample takes to attain 90% of the equilibrium shear stress value after a jump from high rate to low shear rate. The "recovery time" of a paste can be determined by a simple rheology test known as a shear jump experiment. The shear jump experiment is conducted by first applying a high shear rate to the sample followed by a low shear rate while recording shear stress. During the low shear rate segment of the test, a thixotropic material will start with a low shear stress that will gradually recover to an equilibrium value. The thick-film pastes are tested using a high shear rate of 2 $s^{-1}$ and a low shear rate of 0.1 $s^{-1}$.

As used herein, "shear thinning index (STI)" refers to the ratio of the viscosity measured at 1 $s^{-1}$ to the viscosity measured at 10 $s^{-1}$.

As used herein, "fineness of grind" refers to the reading obtained on a grind gauge under specified test conditions that indicates the size of the largest particles in a finished dispersion, but not average particle size or concentration of sizes. The Fineness of Grind (FOG) test method (ASTM D1316 - 06(2011)) can be used to measure fineness of grind.

As used herein, the term "dopant" refers to an additive that can change the electrical conductivity of composition. Such dopants include electron-accepting (*i.e.,* acceptor) dopants and electron-donating (*i.e.,* donor) dopants.

As used herein, the term "electrically conductive" refers to having an electrical property such that a charge or electrons or electric current flows through the material.

As used herein, "thixotropy" refers to the time and shear rate dependence of viscosity of a fluid.

As used herein, the term "thixotropic" refers to a property of a metallic paste composition that enables it to flow when subjected to a mechanical force such as a shear stress or when agitated and return to a gel-like form when the mechanical force is removed. A thixotropic fluid can be applied to a surface, generally without regard to the orientation of the surface, by a variety of processes without the fluid running, slumping or sagging while it dries or is further processed.

As used herein, a "thixotropic modifying agent" refers to a compound, such as an amide wax as used herein, that when added to a fluid composition modulates the rheology of the fluid, alone or in combination with other components of the fluid, so that the fluid is thixotropic or exhibits thixotropy. A thixotropic modifying agent can function to prevent sagging of a composition to which it is added.

As used herein, the term "amide-based wax" includes polyamide-based waxes and blends of amide-based waxes and polyamide-based waxes.

As used herein, the term "article of manufacture" is a product that is made and sold and that includes a container and packaging, and optionally instructions for use of the product.

As sued herein, "molecular weight" of a resin refers to weight average molecular weight.

In the examples, and throughout this disclosure, all parts and percentages are by weight (wt% or mass%) and

all temperatures are in °C, unless otherwise indicated.

## II. Screen Printing

In the prior art, the thickness of grid lines achievable by conventional pastes and screen printing processes is quite limited, which hinders their performance in various applications, such as, *e.g.,* in the improvement of solar cell efficiency, especially for solar cells with a shallow emitter. This can be attributed to sticking of paste materials to the screen and slumping, which leads to unwanted line spreading of printed lines after printing and during subsequent drying, sintering and print processing.

The thick film paste compositions provided herein can be formulated for screen printing. The preferred viscosity of the paste for screen printing is 50 Pa·s to 250 Pa·s at 10 $sec^{-1}$, measured at 25°C using a parallel plate geometry viscometer (*e.g.*, an AR2000ex Viscometer from TA Instruments). When the thick film paste compositions provided herein are used in screen printing, paste sticking to the screen is minimized, recovery time is reduced, and high elastic moduli is maintained at elevated temperatures, which equates to faster recovery time and minimization or elimination of sagging during drying. Preferably, high melting-point thixotropy modifying agents, particularly wax thixotropes having a melting point of greater than at or about 110°C, are incorporated into the paste formulations to enable fine-line printing with high (thickness/width or height/width) aspect ratio, which is maintained through drying and subsequent firing.

The thick film paste compositions provided herein can be used to produce high-density, fine-line features using printing techniques, such as screen printing techniques, on a substrate. The resulting substrate includes a printed feature, such as a line or finger, suitable for semiconductor device assemblies with high interconnection density, or in the construction and fabrication of solar cells.

In screen printing methods of printing using thick-film paste compositions, such as provided herein, a screen stencil can be prepared by masking or blocking-off portions of a fine screen using methods well known in the art. Once the screen has been appropriately prepared, it is used as a stencil for printing on a substrate. A thick-film paste composition provided herein, containing electrically conducting particles, is forced through the screen stencil onto the surface of the substrate. The thick-film paste composition then is appropriately cured to form solid conductors on the substrate. The curing process will vary depending upon the composition of the specific conductor paste and the substrate that is used.

The thick-film paste compositions provided herein can include a solvent. The solvent evaporates upon drying and/or firing. The thick-film paste compositions provided herein also can include glass frits, which generally are or contain a melted-glass composition that is finely ground. Glass frits particularly are included in the thick-film paste compositions when the paste compositions are to be printed as a "trace" on the substrate. Upon sintering, the glass frit melts and coalesces, primarily at the surface of the trace/substrate, providing adhesion to the substrate. The conductive metal particles in the thick-film paste composition come into contact with each other, bind together or fuse under heat to provide the conductive characteristics of the electronic formation or printed feature. Sintering can be achieved, *e.g.*, using a conduction oven, an IR oven/furnace, by induction (heat induced by electromagnetic waves) or using light ("photonic") curing processes, such as a highly focused laser or a pulsed light sintering system (*e.g.*, available from Xenon Corporation (Wilmington, MA USA) or from NovaCentrix (Austin, TX).

The conductive thick-film paste compositions provided herein can be used to form any electronic feature, such as conductive grids, conductive patterns or metal contacts, on a substrate. The electronic features formed by the conductive pastes provided herein have a number of attributes that make them useful in semiconductor device assemblies with high interconnection density, or in the construction and fabrication of solar cells. For example, the conductive pastes form an electronic feature that has a high conductivity, in some instances close to that of a dense, pure metal, that exhibits good adhesion to the substrate and that can be formed on a variety of substrates, particularly silicon. The conductive thick-film paste compositions provided herein can be printed to form fine lines (e.g., having a width of 70 microns) with good edge definition and excellent conductivity (close to the resistivity of the bulk conductor) after sintering by heating or laser treatment.

## III. Conductive Inks and Pastes

Conductive inks or pastes are known in the art. For example, U.S. Pat. No. 6,517,931 (Fu, 2003) describes silver ink for forming electrodes. The ink is described as containing silver powder free of palladium and gold and as including a powdered ceramic metal oxide inhibitor, such as barium titanate to promote adhesion between the dielectric and electrode layers subsequent to firing. The ink also is described as containing a hydrogenated castor oil wax as a thixotrope. The patent describes the use of the silver ink as termination pastes for multilayer chip-type ceramic capacitors (MLCC). MLCCs contain a plurality of interleaved and staggered layers of an electrically conductive film of metal (electrodes) formed by deposition (usually by screen printing) of a thick film paste or ink, and electrically insulating layers of a dielectric ceramic oxide.

U.S. Pat. No. 6,982,864 (Sridharan et al., 2006) describes copper termination inks that contain glass that is

free of lead and cadmium and use of the inks on MLCCs. The inks are described as containing copper particles, a solvent, a resin and thixotropic agent such as hydrogenated castor oil, silicates and derivatives thereof.

U.S. Pat. No. 7,494,607 (Wang et al., 2009) describes electro-conductive thick film compositions and electrodes and semi-conductive devices formed therefrom. The thick film compositions are described as containing electro-conductive metal particles, glass frit as an inorganic binder and an organic medium that can contain ethyl cellulose, ethylhydroxyethyl cellulose, wood rosin, mixtures of ethyl cellulose and phenolic resins, polymethacrylates of lower alcohols, monobutyl ether of ethylene glycol monoacetate ester alcohols and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters.

U.S. Pat. No. 7,504,349 (Brown et al., 2009) describes lead-free and cadmium-free conductive copper thick film pastes that exhibit good solderability and a low firing temperature. The thick film pastes are described as containing copper particles and lead-free and cadmium-free glass particles. Brown *et al.* teaches that commonly used thixotropic agents such as hydrogenated castor oil based thixotropes can be included but that it is not always necessary to incorporate a thixotropic agent because the solvent/resin properties may alone provide suitable rheological properties.

U.S. Patent Appl. Publication US2009/0298283 (Akimoto et al., 2009) describes conductive compositions and processes for use in manufacture of semiconductor devices. The conductive compositions are described as containing an electrically conductive powder, glass frits and an organic medium selected among bis(2-(2-butoxyethoxy)ethyl)-adipate, dibasic ester, octyl-epoxy-tallate, isotetradecanol and pentaerythritol ester of hydrogenated rosin.

Some of the difficulties encountered using thick film compositions known in the art include the inability to forming high-aspect ratio (height:width, i.e., tall) patterns, lines or fingers; increased resistance, poor adhesion or reduced adhesion performance; limited current carrying capability in fine lines or fingers or decreased electrical performance; and difficulties and/or expense in forming complicated fine-line patterns.

The conductive thick film pastes provided herein enable fine-line printing of conductor grids with high aspect ratio, which reduces the line resistivity and hence improves the performance of the electronic features produced using the pastes. The thickness of the printed grid lines achievable by the pastes of the present invention is significantly higher than those from conventional pastes. The conductive thick film paste compositions provided herein can be deposited/printed on many different substrates, such as, e.g., uncoated or silicon nitride-coated multicrystalline or single crystalline silicon substrates and combinations thereof, using traditional printing techniques, such as screen printing.

In particular, the conductive thick film pastes provided herein can be used for metallizing (providing with metal contacts that are electrically conductive) a silicon wafer for fabrication of a silicon solar cell. The electrodes can be made, *e.g.,* by screen printing the conductive thick film pastes provided herein. The substrate for a silicon solar cell can include uncoated or silicon nitride-coated multicrystalline and single crystalline silicon wafers. For example, the conductive thick film pastes provided herein can contain silver particles and can be screen printed on one side of a silicone substrate and dried to form a front electrode, and a conductive thick film paste provided herein containing silver particles or silver and aluminum particles can be screen printed and dried on the backside of the substrate. The substrate then can be sintered or fired using any method known in the art. An exemplary method of firing the substrate is exposing the printed substrate to elevated temperatures, such as in the range of from 500°C to 950°C in an infrared furnace for a period of time sufficient to sinter the printed electronic features on the substrate, such as from several minutes to an hour or more. In such applications, the aluminum can diffuse from the paste into the silicon substrate and can help to form the back surface field layer, which can help to improve the energy conversion efficiency of the solar cell.

## IV. Metallic Paste Compositions Containing Wax Thixotropes Provided Herein

The conductive thick film pastes provided herein include greater than 50% by weight electrically conductive metal particles; a thixotropic modifying agent containing an amide-based wax or polyamide-based wax having a melting point greater than 110°C; glass frit and a resin, where the printing paste has a recovery time less than 10 seconds or a shear-thinning index of 10 or greater or both. The conductive thick film pastes provided herein further can include a dispersant. The conductive thick film pastes provided herein further can include particles of a metal oxide. The conductive thick film pastes provided herein further can include a solvent. The conductive thick film pastes provided herein further can include a compound selected from among a dopant, an adhesion promoter, a coupling agent, a leveling agent, a defoamer or a combination thereof.

### 1. Electrically Conductive Metal Particles

The conductive thick film pastes provided herein include electrically conductive metal particles. Non-limiting examples of metals that can be included in the conductive thick film pastes provided herein include silver, gold, copper, aluminum, nickel, cobalt, chromium, indium, iridium, iron, lead, palladium, platinum, osmium, rhodium, ruthenium, tantalum, tin, tungsten and zinc combinations or alloys thereof. The metal particles that exhibit a low bulk resistivity from

about 0.5 μΩ·cm to 50 μΩ·cm, preferably from at or about 1 μΩ·cm to 30 μΩ·cm, or 0.5 μΩ·cm to 5 μΩ·cm, most preferably from at or about 1 μΩ·cm to 20 μΩ·cm can be included in the conductive thick film pastes provided herein. For example, gold has a bulk resistivity of 2.25 μΩ·cm. Copper has a bulk resistivity of 1.67 μΩ·cm. Silver, has a bulk resistivity of 1.59 μΩ·cm. Silver, being the most conductive metal, is the most preferred metal particle, although metal particles of alloys of silver also can be included in the conductive paste formulation. Exemplary silver alloys contain aluminum, copper, gold, palladium, platinum or combinations thereof. The metal particles, such as copper or silver particles, also can be coated with a metal. For example, copper metal particles can be coated with silver, providing a less expensive alternative to pure silver particles and that can be more conductive and environmentally stable than pure copper particles. Other metals that can be used as coatings include gold, copper, aluminum, zinc, iron, platinum and combinations thereof.

The amount of electrically conductive metal particles in the thick film pastes provided herein generally is greater than 50 wt% (based on the weight of the paste composition). The amount of electrically conductive metal particles in the thick film pastes provided herein can be from 51wt% to 95 wt%, more preferably in the range of 60 wt% to 90 wt% and particularly in the range of 75 wt% to 90 wt%. For example, the electrically conductive metal particles in the thick film paste compositions provided herein can be present in an amount that is 50.5 wt%, 51 wt%, 51.5 wt%, 52 wt%, 52.5 wt%, 53 wt%, 53.5 wt%, 54 wt%, 54.5 wt%, 55 wt%, 55.5 wt%, 56 wt%, 56.5 wt%, 57 wt%, 57.5 wt%, 58 wt%, 58.5 wt%, 59 wt%, 59.5 wt%, 60 wt%, 60.5 wt%, 61 wt%, 61.5 wt%, 62 wt%, 62.5 wt%, 63 wt%, 63.5 wt%, 64 wt%, 64.5 wt%, 65 wt%, 65.5 wt%, 66 wt%, 66.5 wt%, 67 wt%, 67.5 wt%, 68 wt%, 68.5 wt%, 69 wt%, 69.5 wt%, 70 wt%, 70.5 wt%, 71 wt%, 71.5 wt%, 72 wt%, 72.5 wt%, 73 wt%, 73.5 wt%, 74 wt%, 74.5 wt%, 75 wt%, 75.5 wt%, 76 wt%, 76.5 wt%, 77 wt%, 77.5 wt%, 78 wt%, 78.5 wt%, 79 wt%, 79.5 wt%, 80 wt%, 80.5 wt%, 81 wt%, 81.5 wt%, 82 wt%, 82.5 wt%, 83 wt%, 83.5 wt%, 84 wt%, 84.5 wt%, 85 wt%, 85.5 wt%, 86 wt%, 86.5 wt%, 87 wt%, 87.5 wt%, 88 wt%, 88.5 wt%, 89 wt%, 89.5 wt%, 90 wt%, 91.5 wt%, 92 wt%, 92.5 wt%, 93 wt%, 93.5 wt%, 94 wt%, 94.5 wt% or 95 wt% (by weight of the paste composition).

The electrically conductive metal particles can be of any geometry. Typically the particles can have a diameter or width or length between 1 nm to 10 μm. For example, the particles can have a diameter (width) of 10 μm or less. The particles can have a diameter (width) of 6 μm or less. The particles can have a diameter of 1 μm or less. The average particle diameter of the conductive metal particles can be within the range of about 5 nm to 5000 nm or 500 nm to 1500 nm. The conductive metal particles, such as silver particles, can be described in terms of particle size at $D_{10}$, $D_{50}$, and $D_{90}$, which corresponds to particle sizes where 10%, 50% and 90% respectively of the particles are below the specified diameter. Exemplary conductive metal particles can have a $D_{90}$ of 1-10 microns, such as a $D_{90}$ of 8 microns or a $D_{90}$ of 5.5 microns or a $D_{90}$ of 2.5 microns. Exemplary conductive metal particles can have a $D_{50}$ of 0.5-5 microns, such as a $D_{50}$ of 2.5 microns, or $D_{50}$ of 1.5 microns. Exemplary conductive metal particles can have a $D_{10}$ of 0.1-1.5 microns, such as a $D_{10}$ of 1 micron or a $D_{10}$ of 0.5 micron. A preferred conductive metal particle is a silver particle having a $D_{10}$ of 1 micron, $D_{50}$ of 2.1 microns, and a $D_{90}$ of 5.3 microns.

The particles can be cubes, cylinders, disks, ellipsoids, fibers, flakes, granules, needles, prisms, pyramids, rings, rods, spheres, spheroids (prolate or oblate), ovoids or random non-geometric shapes. In particular, the particles can be spherical, spheroidal or flakes.

**2. Thixotropic Modifying Agent**

The conductive thick film pastes provided herein include a thixotropic modifying agent. A preferred thixotropic modifying agent is a high temperature thixotropic modifying agent, particularly an amide-based wax and/or polyamide-based wax. A particularly preferred thixotropic modifying agent is an amide-based wax and/or polyamide-based wax having a melting point greater than at or about 110°C.

As demonstrated in the Examples, amide wax and/or polyamide wax thixotropes and their combination are effective in enhancing thixotropic recovery (reducing the time for recovery) and are effective for providing temperature resistance, particularly for elastic modulus. Temperature resistance (high melting point) of the amide wax and/or polyamide wax thixotrope helps prevent sagging or slumping of printed features during drying at elevated temperatures.

The amide wax and/or polyamide wax thixotrope can include a fatty amide. Exemplary fatty amides include, but are not limited to, primary fatty amides (e.g., unsubstituted monoamides), secondary or tertiary fatty amides (e.g., substituted monoamides including fatty alkanolamides), and fatty bis-amides (e.g., substituted bisamides). For example, the primary fatty amides can be of the general formula R-$CONH_2$ where R is a long chain hydrocarbon, generally derived from acids obtained from animal or vegetable sources, containing methylene, alkyl (e.g., methyl), methine or alkene groups. The hydrocarbon R can include between 6 and 30 carbons, preferably between 12 and 24 carbons. For example, the fatty amide can be $CH_3(CH_2)_xCONH_2$, where x is between 6 and 28, preferably between 14 and 22. A particular fatty amide that can be included in the paste composition is a fatty amide where x - 16, which is stearamide (octadecanamide).

Particular examples of fatty amides that can be included in wax thixotrope compositions include behenamide (docosanamide), capramide, caproamide, caprylamide, elaidamide, erucamide (cis-13-docosenamide), ethylene bis-octadecanamide, ethylene bis-oleamide, lauramide (dodecanamide), methylene bis-octadecanamide, myristamide, oleamide (cis-9-octadecenamide), palmitamide, pelargonamide, stearamide (octadecanamide), stearyl stearamide, Thixcin R (castor wax derivative), ASA-T-75F (hydrogenated castor oil/amide wax from Itoh Oil Chemical Co., Ltd.), CRAYVALLAC SF (hydrogenated castor oil/amide wax, from Cray Valley, Exton, PA), CRAYVALLAC Super (amide wax mixture, mostly octadecanamide, from Cray Valley, Exton, PA), Rosswax 141 (polyamide wax, Frank B Ross, Co., Jersey City, NJ), Disparlon 6650 (polyamide wax, Kusomoto Chemicals, Ltd., Japan). The melting points for exemplary amide waxes and polyamide waxes are shown in Table 1 below. The amide waxes and/or polyamide waxes can be used alone or in any combination.

Examples of commercially available amide wax thixotropic modifying agents include Disparlon® 6500, Disparlon® 6600, Disparlon® 6900-20X, Disparlon® 6900-20XN, Disparlo®n 6900-10X, Disparlon® 6810-20X, Disparlon® 6840-10X, Disparlon® 6850-20X, Disparlon® A603-20X and Disparlon® A650-20X (products of Kusumoto Chemicals, Ltd.); A-S-A T-1700 and A-S-A T-1800 (products ofItoh Oil Chemicals Co, Ltd.); TALEN VA-750B and TALEN VA-780 (products of Kyoeisha Chemical Co, Ltd.); and Crayvallac SF and Crayvallac Super® (products of Cray Valley, Exton, PA).

**Table 1. Melting Points of Exemplary Amide or Polyamide Waxes**

| Compound | Melting Point (°C) |
|---|---|
| behenamide (docosanamide) | 110-113 |
| capramide | 98 |
| caproamide | 100-102 |
| caprylamide | 105-110 |
| elaidamide | 91-93 |
| erucamide (cis-13-docosenamide) | 79 |
| ethylene bis-octadecanamide | 135-146 |
| ethylene bis-oleamide | 115-118 |
| lauramide (dodecanamide) | 99 |
| methylene bis-octadecanamide | 148-150 |
| myristamide | 105-107 |
| palmitamide | 106 |
| pel argonamide | 90-92 |
| stearamide (octadecanamide) | 102-104 |
| stearyl stearamide | 98 |
| Thixcin R (castor wax derivative) | 85 |
| [1]ASA-T-75F (Itoh Oil Chemical Co., Ltd.) | 115-125 |
| [1]CRAYVALLAC SF (Cray Valley) | 130-140 |
| [2]CRAYVALLAC Super (Cray Valley) | 120-130 |
| [3]Rosswax 141 (Frank B Ross, Co., Jersey City, NJ) | 141 |
| [1]Hydrogenated castor oil + amide wax<br>[2]Amide wax mixture (mostly octadecanamide)<br>[3]Polyamide wax | |

A preferred material is the amide-based wax Crayvallac Super® (where the primary component is octadecanamide wax), a high melting point wax thixotropic agent, particularly in front side thick film silver paste formulations. Incorporation of high melting point amide-based and/or polyamide-based wax thixotropic modifying agents improves the aspect ratio of as-printed finger lines and prevents slumping of printed lines during drying and/or sintering. The thixotropic modifying agent can be selected to have a melting point ≥ 100°C, or ≥ 110°C, or ≥ 120°C, or ≥ 130°C, or ≥ 140°C or ≥ 150°C. The thixotropic modifying agent can be selected to have a melting point that is within ±10°C of the processing temperature of the printed feature, such as having have a melting point at least 10°C higher than the drying temperature,

in order to prevent sagging during drying and processing.

The amide-based wax and/or polyamide-based wax and/or a composition containing the amide-based wax and polyamide-based wax, alone or in combination with other waxes, can be selected to have a melting point of at or about 100°C - 180°C, or 105°C - 180°C, or 110°C - 175°C, or 110°C - 170°C, or 115°C -170°C, or 120°C - 170°C, or 125°C - 165°C, or 120°C - 160°C, or 125°C - 165°C, or 130°C - 170°C, or 120°C - 180°C, or ≥ 100°C, or ≥ 105°C, or ≥ 110°C, or ≥ 115°C, or ≥ 120°C, or ≥ 125°C, or ≥ 130°C, or ≥ 135°C or ≥ 140°C. The melting point can be measured by any method known in the art, e.g., by a dropping point device such as Model FP83HT Dropping Point Cell sold by Mettler-Toledo International, Inc. (CH-8606 Greifensee, Switzerland). Melting point of the waxes also can be determined by ASTM test method D-127.

Thixotropic modifying agents, preferably high temperature thixotropic modifying agents, such as polyamide-based waxed and/or amide-based waxes having a melting point at or about 100°C - 180°C, generally greater than 110°C, can be incorporated into the thick film paste compositions provided herein in a range of from at or about 0.1 wt% to 4 wt% based on the weight of the paste composition, particularly in a preferred range of 0.2 wt% to 2 wt%, more preferably in the range of 0.4 wt% to 1.5 wt%. For example, the thixotropic modifying agent in the thick film paste compositions provided herein can be present in an amount that is 0.1 wt%, 0.125 wt%, 0.15 wt%, 0.175 wt%, 0.2 wt%, 0.225 wt%, 0.25 wt%, 0.275 wt%, 0.3 wt%, 0.325 wt%, 0.35 wt%, 0.375 wt%, 0.4 wt%, 0.425 wt%, 0.45 wt%, 0.475 wt%, 0.5 wt%, 0.75 wt%, 1 wt%, 1.25 wt%, 1.5 wt%, 1.75 wt%, 2 wt%, 2.25 wt%, 2.5 wt%, 2.75 wt%, 3 wt%, 3.25 wt%, 3.5 wt%, 3.75 wt% or 4 wt% based on the weight of the paste composition.

### 3. Resin

The conductive thick film pastes provided herein include a resin. The resin can be selected so that it can be dissolved in the solvent of the thick film paste composition. The resin can be selected so that it is of a molecular weight that allows the resin to be dissolved in the solvent of the composition in an amount of up to 5 wt% based on the weight of the paste composition. The resin helps build viscosity of the paste composition, which assists in dispersion of materials during manufacture. Exemplary resins include synthetic or natural resins, such as acrylic resin, bisphenol resin, coumarone resin, ethyl cellulose resin, phenol resin, polyester resin, rosin resin, rosin ester resin, styrene resin, terpene resin, terpene phenol resin and xylene resin. Examples of preferred resins include ethyl cellulose resins, acrylic resins, and rosin ester resins. A particularly preferred ethyl cellulose resin has a molecular weight of 20,000 to 40,000. A particularly preferred rosin ester resin has a molecular weight of 1,000 to 2,000. The molecular weight of the resin can dictate the amount of resin that can be included. Resins of a lower molecular weight (such as less than 2,000) can be included in the paste concentrations provided herein at higher concentrations than can resins of higher molecular weight (such as from 20,000 to 50,000).

Other suitable resins readily can be identified by those skilled in the art. Resins that can be included in the thick film paste compositions provided herein can be selected to have one or more of the following characteristics - the resin: (1) is compatible with the chosen organic solvent of the paste formulation; (2) increases the thixotropic index of the paste when used in combination with the wax thixotrope at low resin content in the paste composition; (3) decomposes quickly and without leaving residues that negatively impact electric properties during the burnout phase of the rapid thermal processing (co-firing of the paste) which can occur in 5 to 45 seconds at temperatures at about 500°C +/- 100°C or can include exposing the printed substrate to elevated temperatures, such as in the range of from 500°C to 950°C for a period of time sufficient to sinter the printed electronic features on the substrate, such as from several seconds to minutes to an hour or more; and (4) does not produce or release corrosive chemical entities (such as halides) or materials susceptible to degrading the conductivity of the paste either after printing, thermal processing or during end-use (for instance with regard to hydrolytic stability or other environmental stability tests performed after co-firing of the paste). Ideally, the selected resins work in synergy with the inorganic ingredients of the paste composition to provide the appropriate paste rheology and fired conductor properties.

The amount of resin in the thick film pastes provided herein generally is less than 5 wt% (based on the weight of the paste composition), in particular in the range of 0.05 wt% to 5 wt% or in the range of 0.01 wt% to 2 wt%. For example, the resin in the thick film paste compositions provided herein can be present in an amount that is 0.01 wt%, 0.025 wt%, 0.05 wt%, 0.075 wt%, 0.1 wt%, 0.125 wt%, 0.15 wt%, 0.175 wt%, 0.2 wt%, 0.225 wt%, 0.25 wt%, 0.275 wt%, 0.3 wt%, 0.325 wt%, 0.35 wt%, 0.375 wt%, 0.4 wt%, 0.425 wt%, 0.45 wt%, 0.475 wt%, 0.5 wt%, 0.75 wt%, 1 wt%, 1.25 wt%, 1.5 wt%, 1.75 wt%, 2 wt%, 2.25 wt%, 2.5 wt%, 2.75 wt%, 3 wt%, 3.25 wt%, 3.5 wt%, 3.75 wt%, 4 wt%, 4.25 wt%, 4.5 wt%, 4.75 wt% or 5 wt% based on the weight of the paste composition.

### 4. Dispersant

The conductive thick film pastes provided herein can include dispersants. Any dispersants known in the art can be used. Exemplary dispersants include those described in co-owned U.S. Patent Appl. Publication US2009/0142526

and U.S. Pat. No. 7,254,197, the disclosure of each of which is incorporated herein by reference in its entirety. The dispersant can be added directly to the paste composition, or the particles can be surface treated with the dispersant. For example, the metal particles can be coated with an organic or a polymeric compound. Such surface coating of the metal particles can minimize or eliminate the need for a dispersant to be added directly to the paste formulation in order to disperse the coated particles. For example, the metal particles can be treated with a polymeric compound that acts as an anti-agglomeration substance to prevent significant agglomeration of the particles. In conventional metallic inks or pastes, the small metal particles typically have a strong tendency to agglomerate and form larger secondary particles (agglomerates) because of their high surface energy. Through steric and/or electronic effects of the dispersant acting as an anti-agglomeration agent, the dispersed polymer-coated metal particles are less prone to agglomeration. This minimization or elimination of agglomeration also tends to minimize or prevent sedimentation and thus provides a metal ink or paste that exhibits good storage and printing stability. In paste compositions in which the metal particles are surface treated with a dispersant as an anti-agglomeration agent, although the need for added dispersant in the paste composition is minimized or eliminated, it is understood that dispersant could be added to the paste composition containing metal particles surface-treated with dispersant if desired, e.g., to further enhance performance properties of the paste.

The dispersant can include ionic polyelectrolytes or non-ionic nonelectrolytes. Any dispersant compatible with the other materials in the paste formulations that reduces or prevents agglomeration or sedimentation of uncoated or coated metal particles, such as glass-coated metal particles, can be used. Examples of preferred dispersants include but are not limited to: copolymers with acidic groups, such as the BYK® series, which include phosphoric acid polyester (DISPERBYK®111), block copolymer with pigment affinic groups (DISPERBYK®2155), alkylolammonium salt of a copolymer with acidic groups (DISPERBYK®180), structured acrylic copolymer (DISPERBYK®2008), structured acrylic copolymer with 2-butoxyethanol and 1-methoxy-2-propanol (DISPERBYK®2009), JD-5 series and JI-5 series, including Sun Chemical SunFlo® P92-25193 and SunFlo® SFDR255 (Sun Chemical Corp., Parsippany, NJ USA), Solsperse™ hyperdispersant series (Lubrizol, Wickliffe, OH USA) including Solsperse™ 33000, Solsperse™ 32000, Solsperse™ 35000, Solsperse™ 20000, which are solid polyethylene-imine cores grafted with polyester hyperdispersant, and polycarboxylate ethers such as these in the Ethacryl series (Lyondell Chemical Company, Houston, TX USA), including Ethacryl G (water-soluble polycarboxylate copolymers containing polyalkylene oxide polymer), Ethacryl M (polyether polycarboxylate sodium salt), Ethacryl 1000, Ethacryl 1030 and Ethacryl HF series (water-soluble polycarboxylate copolymers). A particularly preferred dispersant to include in the paste compositions provided herein is SunFlo® P92-25193 (Sun Chemical Corp., Parsippany, NJ USA).

A preferred dispersant is a polymeric dispersant of the structure

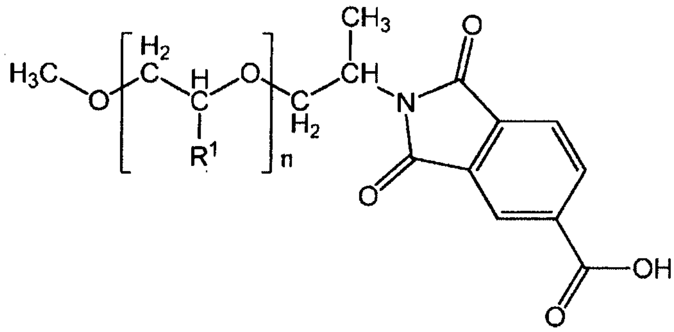

where $R^1$ is H or $CH_3$ and n is an integer from 4 to 200, as described in U.S. Pat. 7,265,197, an example of which is SunFlo® P92-25193 (Sun Chemical Corp., Parsippany, NJ USA).

When present, the total amount of dispersant in the paste composition (including any coated onto the surface of the conductive metal particles) is less than 1.5 wt% (based on the weight of the paste composition). The dispersants can be included in an amount that is in the range of from 0.01 wt% to 1 wt%, in particular in the range of from 0.1 wt% to 0.5 wt%. For example, the dispersant in the thick film paste compositions provided herein can be present in an amount that is 0.01 wt%, 0.025 wt%, 0.05 wt%, 0.075 wt%, 0.1 wt%, 0.125 wt%, 0.15 wt%, 0.175 wt%, 0.2 wt%, 0.225 wt%, 0.25 wt%, 0.275 wt%, 0.3 wt%, 0.325 wt%, 0.35 wt%, 0.375 wt%, 0.4 wt%, 0.425 wt%, 0.45 wt%, 0.475 wt%, 0.5 wt%, 0.525 wt%, 0.55 wt%, 0.575 wt%, 0.6 wt%, 0.625 wt%, 0.65 wt%, 0.675 wt%, 0.7 wt%, 0.725 wt%, 0.75 wt%, 0.775 wt%, 0.8 wt%, 0.825 wt%, 0.85 wt%, 0.875 wt%, 0.9 wt%, 0.925 wt%, 0.95 wt%, 0.975 wt% and 1.0 wt%, based on the weight of the paste composition.

### 5. Metal Oxide

The conductive thick film pastes provided herein can include particles of metal oxides. The metal oxides can

be included as sintering aids. Exemplary metal oxides include aluminum oxides, antimony pentoxide, cerium oxide, copper oxides, gallium oxide, gold oxides, hafnium oxide, indium oxides, iron oxides, lanthanum oxides, molybdenum oxides, nickel oxide, niobium oxide, selenium oxides, silver oxides, strontium oxide, tantalum oxides, titanium oxides, tin oxides, tungsten oxides, vanadium pentoxide, yttrium oxide, zinc oxides and zirconium oxides and combinations thereof. A preferred metal oxide is a zinc oxide.

When present, the amount of metal oxide particles in the thick film pastes provided herein generally is 10 wt% (based on the weight of the paste composition) or less, such as 1 wt% to 10 wt%, in particular in the range of 3 wt% to 7 wt%. For example, the metal oxide particles in the thick film paste compositions provided herein can be present in an amount that is 0.1 wt%, 0.25 wt%, 0.5 wt%, 0.75 wt%, 1 wt%, 1.25 wt%, 1.5 wt%, 1.75 wt%, 2 wt%, 2.25 wt%, 2.5 wt%, 2.75 wt%, 3 wt%, 3.25 wt%, 3.5 wt%, 3.75 wt%, 4 wt%, 4.25 wt%, 4.5 wt%, 4.75 wt%, 5%, 5.25 wt%, 5.5%, 5.75 wt%, 6 wt%, 6.25 wt%, 6.5 wt%, 6.75 wt%, 7 wt%, 7.25 wt%, 7.5 wt%, 7.75 wt%, 8 wt%, 8.25 wt%, 8.5 wt%, 8.75 wt%, 9 wt%, 9.25 wt%, 9.5 wt%, 9.75 wt% or 10 wt% based on the weight of the paste composition.

**6. Glass Frit**

The conductive thick film pastes provided herein can include particles of glass frit. The glass frit can be included as a sintering aid. The glass frits generally are dispersed in an organic medium prior to incorporation into the thick film pastes provided herein, but can be incorporated in any order. Any glass frit known in the art can be included in the thick film paste composition. For example, a glass frit with a softening point of in the range of 300-550° C can be selected. Although glass frit with a higher melting point can be selected, increased sintering times and temperatures may be required for appropriate sintering. Exemplary glass frit includes bismuth-based glasses and lead borosilicate-based glass. The glass can contain one or more of $Al_2O_3$, BaO, $B_2O_3$, BeO, $Bi_2O_3$, $CeO_2$, $Nb_2O_5$, PbO, $SiO_2$, $SnO_2$, $TiO_2$, $Ta_2O_5$, ZnO and $ZrO_2$. Other inorganic additives optionally can be included to increase adhesion without impacting electrical performance. Exemplary additional optional additives include one or more of Al, B, Bi, Co, Cr, Cu, Fe, Mn, Ni, Ru, Sb, Sn, Ti or $TiB_2$, or an oxide of Al, B, Bi, Co, Cr, Cu, Fe, Mn, Ni, Ru, Sn, Sb or Ti, such as $Al_2O_3$, $B_2O_3$, $Bi_2O_3$, $Co_2O_3$, $Cr_2O_3$, CuO, $Cu_2O$, $Fe_2O_3$, $LiO_2$, $MnO_2$, NiO, $RuO_2$, $TiB_2$, $TiO_2$, $Sb_2O_5$ or $SnO_2$. If present the average diameter of the glass frits and/or optional inorganic additives is in the range of 0.5-10.0 $\mu$m, such as less than 5 $\mu$m or less than 2 $\mu$m. If present, any optional inorganic additive generally is present in an amount less than 1 wt% based on the weight of the paste composition, or less than 0.5 wt%.

When present, the glass frits are present in an amount of 10 wt% or less of the paste composition, such as in a range of from 0.1 wt% to 10 wt%, and particularly in the range of 1 wt% to 5 wt%. For example, the glass frit can be present in an amount that is 0.1 wt%, 0.25 wt%, 0.5 wt%, 0.75 wt%, 1 wt%, 1.25 wt%, 1.5 wt%, 1.75 wt%, 2 wt%, 2.25 wt%, 2.5 wt%, 2.75 wt%, 3 wt%, 3.25 wt%, 3.5 wt%, 3.75 wt%, 4 wt%, 4.25 wt%, 4.5 wt%, 4.75 wt%, 5%, 5.25 wt%, 5.5%, 5.75 wt%, 6 wt%, 6.25 wt%, 6.5 wt%, 6.75 wt%, 7 wt%, 7.25 wt%, 7.5 wt%, 7.75 wt%, 8 wt%, 8.25 wt%, 8.5 wt%, 8.75 wt%, 9 wt%, 9.25 wt%, 9.5 wt%, 9.75 wt% or 10 wt% based on the weight of the paste composition.

**7. Solvent**

The conductive thick film pastes provided herein can include a solvent or a combination of solvents. The solvents in the conductive thick film pastes provided herein evaporates after printing. In some application, the solvent is an organic solvent. In some applications, low vapor pressure solvents are preferred. For example, a solvent with less than about 1 mmHg vapor pressure, preferably less than about 0.1 mmHg vapor pressure, can be selected. Solvents with vapor pressure higher than 1 mmHg also can be used in the thick film pastes. Exemplary solvents include texanol, terpineol, butyl carbitol, 1-phenoxy-2-propanol, 2,2,4-trimethyl-1,3-pentanediol di-isobutyrate (TXIB), and mixtures of these solvents.

For some applications, a low vapor pressure solvent can be selected. Any solvent having a boiling point of 100°C or greater and a low vapor pressure, such as 1 mmHg vapor pressure or less, can be used. For example, a low vapor pressure solvent having a boiling point of 100°C or greater, or 125°C or greater, or 150°C or greater, or 175°C or greater, or 200°C or greater, or 210°C or greater, or 220°C or greater, or 225°C or greater, or 250°C or greater, can be selected.

Exemplary low vapor pressure solvents include diethylene glycol monobutyl ether; 2-(2-ethoxyethoxy) ethyl acetate; ethylene glycol; terpineol; trimethylpentanediol monoisobutyrate; 2,2,4-trimethyl-1,3-pentanediol monoisobutyrate (texanol); dipropylene glycol monoethyl ether acetate (DOWANOL® DPMA); tripropylene glycol *n*-butyl ether (DOWANOL® TPnB); propylene glycol phenyl ether (DOWNAL® PPh); dipropylene glycol *n*-butyl ether (DOWANOL® DPnB); dimethyl glutarate (DBE5 Dibasic Ester); dibasic ester mixture of dimethyl glutarate and dimethyl succinate (DBE 9 Dibasic Ester); tetradecane, glycerol; phenoxy ethanol (Phenyl Cellosolve®); dipropylene glycol; benzyl alcohol; acetophenone; $\gamma$-butyrolactone; 2,4-heptanediol; phenyl carbitol; methyl carbitol; hexylene glycol; diethylene glycol monoethyl ether (Carbitol™); 2-butoxyethanol (Butyl Cellosolve®); 1,2-dibutoxyethane (Dibutyl Cellosolve®); 3-butoxybutanol;

and N-methylpyrrolidone.

Solvents having higher vapor pressure also could be used in the thick film pastes provided herein, alone or in combination with low vapor pressure solvents. A partial list of higher vapor pressure solvents includes alcohol, such as ethanol or isopropanol; water; amyl acetate; butyl acetate; butyl ether; dimethylamine (DMA); toluene; and N-methyl-2-pyrrolidone (NMP). It is preferred, however, that the solvents in the aerosol jet inks be limited to solvents having a vapor pressure of less than about 1 mmHg vapor pressure, and more preferably less than about 0.1 mmHg vapor pressure.

The amount of solvent, whether present as a single solvent or a mixture of solvents, in the present thick film paste composition is between 1 wt% to 20 wt% by weight of the paste composition, particularly in the range of 2 wt% to 15 wt%, or in the range of 5 wt% to 12 wt%. For example, the conductive thick film paste compositions provided herein can contain an amount of solvent that is 1 wt%, 1.25 wt%, 1.5 wt%, 1.75 wt%, 2 wt%, 2.25 wt%, 2.5 wt%, 2.75 wt%, 3 wt%, 3.25 wt%, 3.5 wt%, 3.75 wt%, 4 wt%, 4.25 wt%, 4.5 wt%, 4.75 wt%, 5%, 5.25 wt%, 5.5%, 5.75 wt%, 6 wt%, 6.25 wt%, 6.5 wt%, 6.75 wt%, 7 wt%, 7.25 wt%, 7.5 wt%, 7.75 wt%, 8 wt%, 8.25 wt%, 8.5 wt%, 8.75 wt%, 9 wt%, 9.25 wt%, 9.5 wt%, 9.75 wt%, 10 wt%, 10.25 wt%, 10.5 wt%, 10.75 wt%, 11 wt%, 11.25 wt%, 11.5 wt%, 11.75 wt%, 12 wt%, 12.25 wt%, 12.5 wt%, 12.75 wt%, 13 wt%, 13.25 wt%, 13.5 wt%, 13.75 wt%, 14 wt%, 14.25 wt%, 14.5 wt%, 14.75 wt%, 15 wt%, 15.25 wt%, 15.5 wt%, 15.75 wt%, 16 wt%, 16.25 wt%, 16.5 wt%, 16.75 wt%, 17 wt% , 17.25 wt%, 17.5 wt%, 17.75 wt%, 18 wt%, 18.25 wt%, 18.5 wt%, 18.75 wt%, 19 wt%, 19.25 wt%, 19.5 wt%, 19.75 wt%, or 20 wt% based on the weight of the paste composition.

### 8. Additives

The conductive thick film pastes provided herein further can include other additives, e.g., to enhance paste performance, such as a dopant, an adhesion promoter, a coupling agent, a viscosity modifier, a leveling agent, a defoamer, a sintering aid, a wetting agent, an anti-agglomeration agent and any combination thereof. None-limiting examples of additives that can be included in the conductive thick film pastes provided herein include:

- Dopants. Any dopant known in the art can be included in the paste composition.
- Viscosity modifiers. In some applications, the thick film paste can include one or more viscosity modifiers. Exemplary viscosity modifiers include styrene allyl alcohol, hydroxyethyl cellulose, methyl cellulose, 1-methyl-2-pyrrolidone (BYK®410), urea modified polyurethane (BYK®425), modified urea and 1-methyl-2-pyrrolidone (BYK®420), SOLSPERSE™ 21000, polyester, and acrylic polymers.
- Leveling agent. In some applications, the thick film paste can include a leveling agent to decrease surface tension, which allows the paste to flow more readily during application of the paste and can enhance the ability of the paste to wet a surface of the substrate. Any leveling agent known in the art can be included, such as a fluorosurfactant, an organo-modified silicon or an acrylic leveling agent or any combination thereof.
- Sintering Aids. Compounds that aid in the sintering process can be included in the thick film paste composition. Examples of sintering aids that can be included are particles of glass or metal oxides. If present the average diameter of the sintering aid is in the range of 0.5-10.0 $\mu$m, or less than 5 $\mu$m or less than 2 $\mu$m. If present, any sintering aid generally is present in an amount less than 1 wt% based on the weight of the paste composition, or less than 0.5 wt%.
- Wetting agents. Compounds that aid in the wetting of the surface of a substrate or that can modify the surface tension can be included in the thick film paste composition. Examples of such materials include polyether modified polydimethylsiloxane (BYK®307), xylene, ethylbenzene, blend of xylene and ethylbenzene (BYK®310), octamethylcyclo-tetrasiloxane (BYK®331), alcohol alkoxylates (e.g., BYK® DYNWET), ethoxylates and a modified dimethylpolysiloxane copolymer wetting agent (Byk®336).
- Defoaming agents. Some preferred materials include silicones, such as polysiloxane (BYK®067 A), heavy petroleum naphtha alkylate (BYK®088), and blend of polysiloxanes, 2-butoxyethanol, 2-ethyl-1-hexanol and Stoddard solvent (BYK®020); and silicone-free defoaming agents, such as hydrodesulfurized heavy petroleum naphtha, butyl glycolate and 2-butoxyethanol and combinations thereof (BYK®052, BYK®A510, BYK®1790, BYK®354 and BYK®1752).
- Anti-agglomeration agents. The anti-agglomeration agent generally acts by shielding (e.g., sterically and/or through charge effects) the metal particles from each other to at least some extent and thereby substantially prevents a direct contact between individual metal particles. The anti-agglomeration agent does not have to be present as a continuous coating surrounding the entire surface of a metal particle. Rather, in order to prevent a substantial amount of agglomeration of the metal particles, it often will be sufficient for the anti-agglomeration agent to be present on only a portion of the surface of a metal particle. The anti-agglomeration agent can be or contain a polymer, such as an organic polymer. The polymer can be a homopolymer or a copolymer. The organic polymer can be a reducing agent. Exemplary anti-agglomeration agents include as monomers one or a combination of polyvinyl pyrrolidone, vinyl pyrrolidone, vinyl acetate, vinyl imidazole and vinyl caprolactam.

It is preferred that the other compounds be used in amounts less than 5% to minimize their effect on conductivity,

however they could be used at higher amounts, such as between 1 wt% to 15 wt% (based on the weight of the paste composition), in some instances. In some instance, the other compounds are present in the paste composition in an amount between 0.1 wt% to 0.5 wt%. The amount of additives, when present, can be 0.05 wt%, 0.06 wt%, 0.07 wt%, 0.08 wt%, 0.09 wt%, 0.1 wt%, 0.15 wt%, 0.2 wt%, 0.25 wt%, 0.3 wt%, 0.35 wt%, 0.4 wt%, 0.45 wt%, 0.5 wt%, 0.55 wt%, 0.6 wt%, 0.65 wt%, 0.7 wt%, 0.75 wt%, 0.8 wt%, 0.85 wt%, 0.9 wt%, 0.95 wt%, 1.0 wt%, 1.1 wt%, 1.2 wt%, 1.3 wt%, 1.4 wt%, 1.5 wt%, 1.6 wt%, 1.7 wt%, 1.8 wt%, 1.9 wt%, 2.0 wt%, 2.1 wt%, 2.2 wt%, 2.3 wt%, 2.4 wt%, 2.5 wt%, 2.6 wt%, 2.7 wt%, 2.8 wt%, 2.9 wt%, 3.0 wt%, 3.1 wt%, 3.2 wt%, 3.3 wt%, 3.4 wt%, 3.5 wt%, 3.6 wt%, 3.7 wt%, 3.8 wt%, 3.9 wt%, 4.0 wt%, 4.1 wt%, 4.2 wt%, 4.3 wt%, 4.4 wt%, 4.5 wt%, 4.6 wt%, 4.7 wt%, 4.8 wt%, 4.9 wt% or 5.0 wt% based on the weight of the paste composition.

The materials described above and the examples below are compositional examples of pastes that could be used for applications where conductive thick film pastes, such as silver thick film paste compositions, are utilized. An exemplary composition can include any combination of one or more of the components described above. For example, the thick film paste composition can include 50 wt% to 95 wt% electrically conductive metal particles, 0.2 wt% to 2 wt% of a thixotropic modifying agent containing an amide-based wax and/or polyamide-based wax having a melting point between greater than 110°C, and 0.05 wt% to 5 wt% resin, and/or 1 wt% to 20 wt% solvent, such as an organic solvent, and/or 0.01 wt% to 1 wt% dispersant, and/or 0.1 wt% to 10 wt% glass frit, and/or 1 wt% to 10% metal oxide, and/or 0.1 wt% to 15 wt% of any one or combination of an additive selected from among a dopant, an adhesion promoter, a coupling agent, a viscosity modifier, a leveling agent, a sintering agent, a wetting agent, a defoaming agent and an anti-agglomeration agent. The combination of components in the thick film paste composition results in a conductive thick film printing paste that has a recovery time less than 10 seconds or a shear-thinning index of 10 or greater or both.

For some applications, the pastes can be formulated to be screen-printable and to have rheological properties that enable the printing of fine line features having a high aspect ratio. For example, the paste can be formulated to have a viscosity of 50 to 250 Pa·s at 10 $sec^{-1}$ when measured at 25°C using a parallel plate geometry viscometer. Other materials and formulations are possible as long as the resultant pastes preferably meet at least one of several key parameters: (1) a recovery time of preferably less than 10 seconds; (2) an STI of preferably 10 or higher; and (3) high aspect ratio of the printed feature.

It has been shown that if the thick film paste compositions meet the recovery time and/or STI parameters set forth above, the slumping of printed grid lines caused by leveling after printing is minimized. In addition, due to the high melting points of the thixotropy modifying agents, particularly high melting point wax thixotropy modifying agents, the printed grid lines and other printed electronic features maintain fairly high elastic moduli at elevated temperatures, preventing further line slumping during drying and subsequent firing processes. Compared with metallic pastes of the prior art, finer printed grid lines with higher aspect ratios can be obtained by a conventional screen printing process using the thick film paste compositions provided herein. The pastes of the present application produce electric features that exhibit improved efficiency, particularly of crystalline silicon solar cells.

The thick film silver pastes can be formulated to have the desired properties, such as a specific range of recovery time, a specified range of shear thinning index (STI), a high aspect ratio or any combination thereof, by the careful selection of raw materials and their ratio in combination with the thixotropic wax. A formulator will be versed in how to choose raw materials and to vary the proportions thereof to adjust the metallic paste so that it demonstrates the specific profile and properties required, and non-limiting examples are provided herein. Compositional variance can result in differences in performance parameters, such as STI or recovery time, and adjustments to the metallic paste composition, such as by changes in the amounts and/or ratios of components, such as with respect to the amide wax component, or the selection of components, such as the molecular weight of the resin, can modulate the performance parameters. Such performance variance, such as exhibiting a range of STI or a range of recovery times, is within the scope of the invention.

The thick film paste compositions provided herein enable fine-line printing of conductor grids with high aspect ratio, which reduces the line resistivity and hence improves the performance of end-use applications, for example solar cells. The thickness of the printed grid lines achievable by the thick film pastes compositions of the present application is significantly higher than those from conventional pastes and is comparable to the thickness achieved using "hot melt" pastes or "double print" techniques, which require more complex and time consuming processes. This high aspect ratio feature is particularly important for formulating pastes for contacting solar cells with shallow emitters, where the contact resistance is usually higher than those with a low sheet resistivity and hence requiring low line resistivity to obtain a low overall series resistance.

The thick film paste compositions of the present application also can achieve taller, narrower printed lines in combination with higher aspect ratio. This is of importance in the context of solar cells, where taller, narrower lines help provide better cell efficiencies by minimizing shading while avoiding increased losses due to series resistance.

The thick film paste compositions of the present application can be provided as an article of manufacture that can contain a packaging material, within the packaging material a thick film paste composition provided herein, and a label. Packaging materials are well known to those of skill in the art. Examples of packaging materials include, e.g.,

bottles, tubes, containers, buckets, drums and any packaging material suitable for a selected formulation. The articles of manufacture also can include instructions for use of the paste.

**Rheology of the Thick Film Paste Compositions**

The viscosity of the thick film paste compositions can be adjusted to suit the application method selected. In a preferred embodiment, the thick film paste compositions of the present application are formulated to have a rheology suitable for be screenprinting. The thick film paste compositions contain particles or a mixture of particles that can determine the rheological properties of the paste. The particles can be of different materials including, for example electrically conductive materials, electrically insulating materials, dielectric materials, and semiconductor materials. Additionally, the thick film pastes can include other compounds for special purposes such as aids for adhesion or sintering. The particles are carried in a vehicle that contains an appropriate solvent, such as an organic solvent. Other components that are commonly found in the vehicle include resins and binders, dispersants, wetting agents, and rheology modifiers. The conductive thick film pastes of the present application preferably include a solvent and resin and optionally rheology modifiers that yield unique rheological and printing properties.

In order for a paste to squeeze through a screen mesh, especially for fine line patterns, a low viscosity while printing is desired. However, in order to avoid spreading of the printed line, a high viscosity after printing is desired. This leads to the requirement that screen printing pastes for high resolution must exhibit shear-thinning behavior, where the viscosity of the paste is high when the paste is at rest and is low when the paste is under shear. In order to maintain fine line resolution and high aspect ratio, it is important that the paste "recovers" to the high resting viscosity quickly after experiencing the high shear of printing. This time and shear rate dependence of viscosity is known as thixotropy. The "recovery time" of a paste can be determined by a simple rheology test known as a shear jump experiment. The experiment is conducted by first applying a high shear rate to the sample followed by a low shear rate while recording shear stress. During the low shear rate segment of the test, a thixotropic material will start with a low shear stress which will gradually recover to an equilibrium value as shown in Figure 1. This recovery can generally be modeled by an exponential function as shown in the following equation:

$$\tau = b + (a - b)\exp(-t / c)$$

where $\tau$ = shear stress, a and b are fitted coefficients and c is the recovery rate constant.

The key parameter is *c*, the recovery rate constant, where a large value of c denotes a slow recovery time (or long recovery time). An issue with this method of data analysis is that the behavior or some fluids, such as inks or pastes, do not fit this model. To avoid this issue, a "recovery time" can be defined as the time that a sample takes to attain 90% of the equilibrium shear stress value after the jump from high to low shear rate. The thick-film pastes are tested using a high shear rate of 2 $s^{-1}$ and a low shear rate of 0.1 $s^{-1}$.

Another indication of thixotropy is the shear thinning index (STI), which is defined as the ratio of the viscosity measured at 1 $s^{-1}$ to the viscosity measured at 10 $s^{-1}$. All viscosity measurements of the thick film pastes provided herein are carried out using a serrated or cleated parallel plate geometry. The serrated geometry is important to avoid wall slip effects that can be prevalent in pastes with high solids loading.

Paste transfer during screen printing is a complex process. The thickness of wet deposited paste materials is usually lower than the calculated wet film thickness, $t_{wet}$, as expressed by:

$$t_{wet} = EOM + 2d_w \bullet x$$

where *EOM* is the emulsion thickness over mesh, $d_w$ is the mesh wire diameter, and x is the percentage of mesh opening area.

The main discrepancy is caused by the sticking of paste materials to mesh wire and emulsion during screen printing. Previous rheology studies have focused on measurement of shear flow while sticking, an extensional flow property, that has not been addressed. A method to test paste sticking uses a 10 mm x 10 mm glass slide inserted into a paste and then pulled away using any method known in the art, such as a mechanical method, *e.g.,* by using the TA Instruments Q800 Dynamic Mechanical Analyzer. The area under each force-displacement curve is proportional to the energy required to separate the paste from the glass slide and correlates to the energy required for separating the paste from the screen opening during a screen printing paste transfer process. Lowered energy required to separate the pastes from a substrate means the tendency for paste sticking to screen is lowered, allowing thicker deposit of paste materials. The pastes provided herein exhibit improved extensional viscosity - a lowering of apparent extensional viscosity so that

the pastes break cleanly from the surface faster. This results in a reduction in the amount of paste sticking to the screen and thus improved printability.

Another aspect of the thick film pastes of the present application is to incorporate a thixotropy modifying agent or a combination of thixotropy modifying agents into the paste formulation to reduce recovery time of the pastes. While thixotropy modifying agents have been widely adopted and used in thick film pastes formulations, one of the main prior art purposes for adding these agents is to increase the shear thinning index. It is, however, not always necessary according to the prior art to incorporate a thixotropy modifying agent into a paste composition because the solvent/resin properties coupled with the shear thinning inherent in any suspension of particles can alone be suitable in this regard (*e.g.*, see US 7,504,349). Another important aim of the prior art in adding thixotropy modifying agents is to enhance thixotropy, or time dependent viscosity recovery to these pastes. The prior art teaches adding thixotropy modifying agents in order to increase the recovery time after shearing a thixotropic fluid. In contrast, the present invention seeks to reduce the recovery time of the pastes. It has been found that adding a high melting point wax thixotropic modifying agent reduces the recovery time of the pastes. As a result of reduced material sticking to the screen and faster recovery time (less time needed to recover), grid lines with printed thickness greater than 40 μm can be obtained by using a conventional screen printing process, as exemplified in Figure 2.

In addition, the high melting points of the preferred thixotropy modifying agents maintains fairly high elastic moduli of the paste over a wide temperature range, as shown in Figure 4. The elastic modulus of a paste represents its ability to return to its original viscosity after stress is applied and is represented by a ratio of stress to strain. Pastes that maintain high elastic moduli at higher temperature exhibit faster recovery time and reduced line spreading of a feature printed using the paste. Pastes that contain a high melting point wax thixotropic modifying agent that exhibit an elastic modulus of greater than about 1000 Pa at a temperature of 65°C were found to exhibit faster recovery time and reduced line spreading of a feature printed using the paste.

It also has been determined that thick film paste compositions that exhibit a storage modulus (G') of 100% or greater at a temperature of 50°C, or at a temperature of 65°C, were found to exhibit faster recovery time (see Figure 6). For example, a paste formulated with a high melting point wax thixotropic modifying agent (CRAYVALLAC Super®, which has a melting point of 120°C-130°C) does not exhibit slumping during drying and subsequent firing (as shown in Fig. 5A), while a paste formulated with a lower melting point wax thixotropic modifying agent (Tryothix A, which has a melting point of 62°C-67°C) slumped significantly, even at slow drying rates (as shown in Figs. 5B and 5C). The elastic modulus at 65°C of the print paste containing the lower melting point wax was orders of magnitude lower than the elastic modulus of the paste containing a high melting point wax thixotropic modifying agent with a melting point higher than 120°C see Fig. 6).

The rheology of the thick film paste composition can be adjusted by varying the components or the ratio of the components in the paste. For example, the amount and/or molecular weight of the resin or the amount and/or type of wax thixotropic modifying agent or a combination thereof can be varied to adjust the rheology of the paste. A greater amount of a resin having a MW of less than 5,000, such as a rosin ester resin having a molecular weight of about 1000 to 2000, can be included in the composition than a high molecular weight resin, such as an ethyl cellulose resin having a MW of 20,000-40,000. The amount of solids in the paste contributed by the resin having a relatively low MW can result in a rheology that is significantly different from the rheology of a similar paste containing a lower quantity of a higher molecular weight resin. For example, when it is desirable to increase the elastic modulus of the paste, additional wax thixotropic modifying agent can be included in the paste composition, or a wax thixotrope having a higher melting point can be included in the paste composition.

## Sintering

The conductive thick film paste compositions provided herein typically are printed and then sintered, such as by heat treatment at temperatures between 500 to 900 °C. The time and temperature used for sintering can be adjusted according to the printed substrate. For example, in some applications sintering (co-firing of the paste) can occur in 5 to 45 seconds at temperatures of at or about 500°C ± 100°C. In some applications, the printed electronic features are sintered into conductive lines or features at a temperature of at or about 700°C to 900°C for a time of from 1 minute to at or 30 minutes or more. When the electronic feature is a printed fine line, sintering forms 70-150 micron wide lines having very good edge definition and excellent conductivity, with no line breaks. The sintering can be achieved using any method known in the art, such as in conduction ovens, IR ovens/furnaces, or by application of a photonic curing process, such as using a highly focused laser or a pulsed light sintering system, or by induction.

## Substrates

Any substrate onto which an electronic feature is to be printed and fired can be selected. Examples of substrates include silicon semiconductor applications and uncoated or silicon nitride (*e.g.*, $SiN_x$) coated multicrystalline and single

crystalline silicon substrates, such as wafers. The substrate can be part of a device, such as an electronic or photovoltaic device, or can be a solar cell.

The substrate onto which an electronic feature is to be applied can have a smooth or rough surface. The substrate can be modified to be textured, such as to include grooves, ridges, troughs, pyramids or other modifications unto which the electronic feature can be applied. Such textured surfaces can be used on a substrate to be included in a solar cell device, since such texturing can be used as a light trapping technique. Texturing one or more surfaces of a solar cell can scatter the incident light at different angles thus resulting in a longer average light path through the active layer. Including microstructures on a surface, such as periodic or random pyramids on the front surface and a reflective or light scattering surface at the rear of the cell, can be used to improve efficiency. The metallic pastes provided herein can de applied to such textured surfaces to form an electronic feature on the surface. For example, the substrate can contain a plurality of micro-structured areas for efficient light trapping (*e.g.*, as described in US2012/0012741). The substrate can be ablated to provide a textured surface, or to produce troughs or channels to contain electronic features, such as electrodes or connecting lines. For example, the surface can be ablated to form a plurality of troughs, resulting in at least a portion of the surface having a ribbed surface. The metallic pastes provided herein can de applied to such a ribbed surface.

## Printed line width

The conductive thick film paste compositions provided herein can be used to form conductive lines or features with good electrical properties, as well as producing seed layer lines, *e.g.,* on solar cell substrates. For example, the conductive thick film paste compositions provided herein and print methods using the conductive thick film paste compositions provided herein can be used to form conductive features on a substrate, where the features have a feature size (*i.e.,* average width of the smallest dimension) in a wide range of printed line widths, for example not greater than about 200 micrometers (μm); not greater than about 150 μm; not greater than about 100 μm; not greater than about 75 μm. The conductive thick film paste compositions provided herein can result in printed features having a width as small as 70 μm.

## Printed Line Thickness and Aspect Ratio (Height to Width)

Printed line thickness (height) can be modulated by the formulation of the conductive thick film paste compositions provided herein, such as selection of the wax thixotrope or resin or solid content or any combination thereof Printed line height can be measured using any method known in the art, for example, using an optical or a stylus profilometer (*e.g.*, from Nanovea, Irvine, CA USA).

As a result of the reduction in paste material sticking to the screen and a lowered recovery time, grid lines with printed thickness greater than 40 μm, or greater than 50 μm can be obtained by printing the thick film paste composition provided herein using a conventional screen printing process, as exemplified in Figure 2. Typical thickness for printed features using the conductive thick film paste compositions provided herein can have a thickness or print height that is at least 5 μm, 6 μm, 7 μm, 8 μm, 9 μm, 10 μm, 11 μm, 12 μm, 13 μm, 14 μm, 15 μm, 16 μm, 17 μm, 18 μm, 19 μm, 20 μm, 21 μm, 22 μm, 23 μm, 24 μm, 25 μm, 26 μm, 27 μm, 28 μm, 29 μm, 30 μm, 31 μm, 32 μm, 33 μm, 34 μm, 35 μm, 36 μm, 37 μm, 38 μm, 39 μm, 40 μm, 41 μm, 42 μm, 43 μm, 44 μm, 45 μm, 46 μm, 47 μm, 48 μm, 49 μm, 50 μm, 51 μm, 52 μm, 53 μm, 54 μm, 55 μm, 56 μm, 57 μm, 58 μm, 59 μm, 60 μm, 61 μm, 62 μm, 63 μm, 64 μm, 65 μm, 66 μm, 67 μm, 68 μm, 69 μm or 70 μm.

The printed lines formed by the thick film paste composition provided herein can have an aspect ratio (height to width) of from at or about 0.05 to at or about 0.45 and particularly greater than or equal to 0.1, preferably greater than 0.15 or in a range from about 0.25 to 0.45, particularly for lines having a width not greater than 100 microns, or for lines having a width not greater than 80 microns or 70 microns, and particularly an aspect ratio (h/w) in the range of from at or about 0.3 to 0.45.

## Conductivity

The electrically conductive features or lines formed by printing with the conductive thick film paste composition provided herein have excellent electrical properties. By way of a non-limiting example, the printed lines can have a resistivity with good sintering that is not greater than about 5 times, or not greater than about 2 to 5 times the resistivity of the pure bulk metal, particularly when the sintering conditions allow the printed lines to reach resistivity entitlement, *i.e.,* essentially complete sintering. The sheet resistance of a printed silver ink typically is less than 5 ohm/sq, particularly less than 1.5 ohm/sq or less than 0.75 ohm/sq for fine lines after sintering. The sintering can be achieved using any method known in the art, such as in conduction ovens, 1R ovens or furnaces as well as through photonic curing processes, including highly focused lasers or using pulsed light sintering systems (*e.g.*, from Xenon Corporation or NovaCentrix;

also see U.S. Pat. No. 7,820,097).

**Preparation of paste compositions**

The thick film paste compositions provided herein can be made using any method known in the art. In an exemplary method, the resin and thixotropic modifying agent are mixed with a solvent to ensure complete dissolution of the resin and activation of the thixotropic modifying agent. To the resulting mixture composition is added with constant mixing electrically conductive particles, such as silver particles, glass frit, such as lead borosilicate glass frit containing $SiO_2$, PbO, ZnO, $B_2O_3$ and $Al_2O_3$, and any other component of the paste, such as dispersant and a metal oxide, such as zinc oxide, and a wetting agent, such as a modified dimethylpolysiloxane copolymer wetting agent. Mixing is continued until a substantially homogeneous paste is obtained.

After the composition is sufficiently mixed to yield a substantially homogeneous paste, the paste is milled using any type of grinding mill, such as a media mill, ball mill, two-roll mill, three-roll mill, bead mill, and air-jet mill; an attritor; or a liquid interaction chamber. For example, the paste can be repeatedly passed through a 3-roll mill (*e.g.,* from Lehmann Mills, Salem, OH; Charles Ross & Son Company, Hauppauge, New York; or Sigma Equipment Company, White Plains, NY). During milling using a 3-roll mill, the gap can be progressively reduced, such as from 20 μm to 5 μm, in order to achieve a grind reading (*i.e.,* dispersion) of the desired size, such as less than or equal to 15 μm.

**Measurement of particle size and particle size distribution**

A volume average particle size can be measured by using a Coulter Counter™ particle size analyzer (manufactured by Beckman Coulter Inc.). The median particle size also can be measured using conventional laser diffraction techniques. An exemplary laser diffraction technique uses a Mastersizer 2000 particle size analyzer (Malvern Instruments LTD., Malvern, Worcestershire, United Kingdom), particularly a Hydro S small volume general-purpose automated sample dispersion unit. The mean particle size also can be measured using a Zetasizer Nano ZS device (Malvern Instruments LTD., Malvern, Worcestershire, United Kingdom) utilizing the Dynamic Light Scattering (DLS) method. The DLS method essentially consists of observing the scattering of laser light from particles, determining the diffusion speed and deriving the size from this scattering of laser light, using the Stokes-Einstein relationship.

**Methods of evaluating printed line conductivity**

The resistivity of the printed line can be measured using a semiconductor parameter analyzer(e.g., a Model 4200-SCS Semiconductor Characterization System from Keithley Instruments, Inc., Cleveland, OH USA) connected to a Suss microprobe station to conduct measurements in an I-V mode. The sheet resistance of the conductive track (length L, width W and thickness t) was extracted from the equation

$$R = R_{sheet} \times \frac{L}{W}$$

where R is the resistance value measured by the equipment (in Ω), and $R_{sheet}$ is expressed in Ω/square.

**Solar Cells**

The conductive thick film paste compositions provided herein can be used in a broad range of electronic and semiconductor devices. The conductive thick film paste compositions provided herein are especially effective in light-receiving elements, particularly in photovoltaics (solar cells). Such devices can include a electronic feature formed by printing any of the conductive thick film paste compositions provided herein on a substrate, such as a Si substrate, *e.g.*, a Si wafer, following by drying and sintering. For example, after drying, the printed Si wafers can be fired in a furnace with peak temperature settings of 500°C to 950°C for 1 to 10 minutes, depending on the furnace dimensions and temperature settings, yielding a solar cell.

The conductive thick film paste compositions provided herein can be used to form an electrode on a substrate. The paste compositions can be deposited on a substrate, such as be screening printing, and the printed substrate subsequently can be dried and heated, such as by firing, to remove the solvent and to sinter the glass frit. The electrodes so produced can be included in a semiconductor device or a photovoltaic device.

The conductive thick film paste compositions provided herein also can be used in methods of crystalline silicon solar cell front side metallization. The paste compositions can be deposited, such as be screening printing, to the front side of the solar cell.

The conductive thick film paste compositions provided herein also can be used in methods for forming a conductive feature on a substrate. The paste composition is applied by screen printing to a substrate to form a printed substrate, which is dried and heated to form a conductive feature. The heating step can be performed by any method known in the art, such as by sintering in an oven or treating with a photonic curing process or by induction. If an oven is used, the oven can be a conduction oven, a furnace, a convection oven or an IR oven. If a photonic curing process is used, it can include treatment using a highly focused laser or a pulsed light sintering system or a combination thereof

The substrate can be a part of a photovoltaic device, which can include as a component a crystalline silicon. The substrate can be a solar cell wafer. The substrate can be a silicon semiconductor, or an uncoated or silicon nitride-coated multicrystalline or single crystalline silicon substrate or a combination thereof. The method can be used to produce on a substrate a conductive feature that contains a line having a width less than 100 microns that has an aspect ratio (height to width) of from 0.3 to 0.45.

Also provided are methods for minimizing line spreading of a metal conductive thick film paste applied to a substrate by screening printing by including in the thick film paste a high melting point amide- or polyamide-based wax thixotropic modifying agent having a melting point greater than 120°C. A high melting point amide- or polyamide-based wax thixotropic modifying agent having a melting point greater than 120°C can be used to minimize line spreading of a metal conductive thick film paste applied to a substrate by screening printing. The substrate can be or contain an uncoated or a silicon nitride coated crystalline silicon, and can be a solar cell wafer.

## Efficiency and Fill Factor of a Solar Cell

The efficiency and fill factor of a solar cell including the thick film paste compositions provided herein were tested using an I-V Testing System (PV Measurements Inc., Boulder, Colorado). The I-V Testing System is a solar simulator that performs an IV sweep when illuminating a solar cell at a constant 1000 W/$m^2$ with a spectrum that mimics the AM 1.5 solar irradiance spectrum (light scan) as well as an unilluminated IV sweep (dark scan). The scan measures from ~ -0.1 V to ~ 0.7 V, which is sufficient to measure the short-circuit current ($I_{sc}$), open-circuit voltage ($V_{oc}$), and the efficiency. The $I_{sc}$ is the current measured at V=0 while the $V_{oc}$ is the value at which 1=0. The product, I*V is equal to the power, and the efficiency is calculated from the maximum power measured during the sweep:

Efficiency = $P_{max}$/(1000*A) where A is the area of the cell in $m^2$. Typical cells are on the order of 240 $cm^2$ or .024 $m^2$. Typical power is on the order of 4W - which yields a typical efficiency of 16.7%.

In addition, the fill factor can be measured. The fill factor equals $P_{max}$/($V_{oc}$*$I_{sc}$)) from the light IV curve. By taking the dark IV curve, once can measure both the resistance and shunt resistance of the cell, both of which are important in achieving high efficiencies.

To keep efficiencies constant across time and to mitigate effects like the ageing of the illumination lamp, there is a calibration cell that is measured every time that the IV is swept. The calibration cell is able to keep subsequent measurements constant. To measure an improvement in cell efficiency with the two methods, one would typically use a population of 10 cells for each method and measure the efficiency of the population. Due to inherent differences in the wafers, a statistical distribution of efficiencies generally is obtained, and one can compare the means of the distributions to find differences.

## EXAMPLES

The following examples, including experiments and results achieved, are provided for illustrative purposes only and are not to be construed as limiting the claimed subject matter.

### Example 1

#### Preparation of paste compositions

#### A. General procedure

Each of Tables 1-5 below sets forth the weight percent (wt%) of each component of thick film silver paste compositions 1-8 prepared using the following general procedure.

The polymeric resin (if included) and thixotropic modifying agent first were mixed with the solvent, Texanol™ ester alcohol (2,2,4-trimethyl-1,3-pentanediolmono(2-methyl-propanoate); Sigma-Aldrich, St. Louis, MO)) at a high temperature (*e.g.*, >50°C) to ensure complete dissolution of the resin and activation of the thixotropic modifying agent. The composition then was mixed with silver particles ($D_{10}$ = 1 μm, $D_{50}$ = 2.1 μm, $D_{90}$ = 5.3 μm, Ames Goldsmith, South Glens Falls, New York); lead borosilicate glass frit containing $SiO_2$, PbO, ZnO, $B_2O_3$ and $Al_2O_3$ (Viox Corporation, Seattle, WA); zinc oxide (particle size = <5 μm, Sigma-Aldrich, St. Louis, MO); SunFlo® P92-25193 dispersant (Sun

Chemical, Parsippany, NJ); and a modified dimethylpolysiloxane copolymer wetting agent (BYK Additives and Instruments, Wallingford, CT). After the composition was sufficiently mixed, such as to homogeneity, the resulting paste was repeatedly passed through a 3-roll mill (*e.g.*, from Lehmann Mills, Salem, OH; Charles Ross & Son Company, Hauppauge, New York; or Sigma Equipment Company, White Plains, NY). During milling, the gap was progressively reduced from 20 μm to 5 μm in order to achieve a grind reading (*i.e.*, dispersion) of less than or equal to 15 μm.

The Fineness of Grind (FOG) test method (ASTM D1316 - 06(2011)) was used to determine the fineness of grind of the silver paste compositions. Fineness of grind refers to the reading obtained on a grind gauge under specified test conditions that indicates the size of the largest particles in a finished dispersion, but not average particle size or concentration of sizes. The ASTM method uses an NPIRI Grindometer.

To conduct the FOG test, a small sample of the composition was poured into the deep end of the groove on the gauge, then with the scraper blade held at right angles to the gauge with both hands, it was scraped at a steady rate down the length of the gauge. Sufficient downward pressure was exerted on the scraper to clean the level surface of the gauge, but left the channel filled with material. Immediately after draw down, the fineness of grind was determined by viewing the gauge, at a right angle to its length, at a grazing angle. The fineness of grind was determined to be the point along the channel where the material first showed a predominantly speckled appearance and the graduation marks between which the number of particles, in a band 3mm wide across the groove, was in the order of 5 to 10.

**B. Silver paste composition without polymeric resin**

Table 2 below sets forth the components used to make a thick film silver paste composition (Paste 1) that contained Crayvallac Super®, a high melting-point (120-130°C) octadecanamide wax thixotropic modifying agent (Cray Valley, Exton, PA), without any added polymeric resin.

**Table 2. Silver paste composition without polymeric resin.**

| Material | Paste 1 (wt%) |
|---|---|
| Polymeric resin | --- |
| Crayvallac Super® (wax thixotropic modifying agent) | 0.84 |
| Silver particles | 83.05 |
| Lead borosilicate glass frit | 2.58 |
| Zinc oxide | 5.58 |
| SunFlo® P92-25193 dispersant | 0.25 |
| Dimethylpolysiloxane copolymer wetting agent | 0.07 |
| Texanol (solvent) | 7.63 |
| **Total** | **100.00** |

**C. Silver paste compositions with ethyl cellulose polymeric resin and a high melting-point octadecanamide wax thixotropic modifying agent**

Table 3 below sets forth the formulations of three thick film silver paste compositions (Pastes 2-4) that contained Crayvallac Super®, a high melting-point (120-130°C) octadecanamide wax thixotropic modifying agent (Cray Valley, Exton, PA), and Ethocel Standard 4, an ethyl cellulose (EC) polymeric resin (Dow Chemical, Midland, MI).

**Table 3. Silver paste compositions with EC resin and octadecanamide wax thixotrope**.

| Material | Paste 2 (wt %) | Paste 3 (wt %) | Paste 4 (wt %) |
|---|---|---|---|
| EC polymeric resin | 0.04 | 0.45 | 1.14 |
| Crayvallac Super® (thixotropic modifying agent) | 0.67 | 0.40 | 0.66 |
| Silver particles | 81.94 | 81.68 | 82.96 |
| Lead borosilicate glass frit | 2.52 | 2.52 | 2.59 |
| Zinc oxide | 5.49 | 5.49 | 2.10 |

(continued)

| Material | Paste 2 (wt %) | Paste 3 (wt %) | Paste 4 (wt %) |
|---|---|---|---|
| SunFlo® P92-25193 dispersant | 0.25 | 0.25 | 0.25 |
| Dimethylpolysiloxane copolymer wetting agent | 0.06 | 0.06 | 0.07 |
| Texanol (solvent) | 9.03 | 9.15 | 10.23 |
| **Total** | **100.00** | **100.00** | **100.00** |

**D. Silver paste composition with ethyl cellulose polymeric resin and a high melting-point hydrogenated castor oil and amide thixotropic modifying agent**

Table 4 below sets forth the formulation of two thick film silver paste compositions (Pastes 5 and 6) that contained a high melting-point hydrogenated castor oil and amide thixotropic modifying agent, either Crayvallac SF® (Paste 5; 130-140°C m.p.; Cray Valley, Exton, PA) or ASA-T-75F (Paste 6; 115-125°C m.p.; ITOH Oil Chemical Co, LTD., Japan) and Ethocel Standard 4, an ethyl cellulose polymeric resin (Dow Chemical, Midland, MI).

**Table 4. Silver paste compositions with ethyl cellulose (EC) resin and a hydrogenated castor oil/amide thixotrope**

| Material | Paste 5 (wt%) | Paste 6 (wt%) |
|---|---|---|
| EC polymeric resin | 1.14 | 1.14 |
| Crayvallac SF® (thixotropic modifying agent) | 0.66 | --- |
| ASA-T-75F (thixotropic modifying agent) | --- | 0.66 |
| Silver particles | 82.96 | 82.96 |
| Lead borosilicate glass frit | 2.59 | 2.59 |
| Zinc oxide | 2.10 | 2.10 |
| SunFlo® P92-25193 dispersant | 0.25 | 0.25 |
| Dimethylpolysiloxane copolymer wetting agent | 0.07 | 0.07 |
| Texanol (solvent) | 10.23 | 10.23 |
| **Total** | **100.00** | **100.00** |

**E. Silver paste composition with ethyl cellulose polymeric resin and a modified castor oil ester thixotropic modifying agent**

Table 5 below sets forth the formulation of a thick film silver paste composition (Paste 7) that contained Troythix™ A, a modified castor oil ester thixotropic modifying agent (melt point = 62-67°C; Troy Corp., Florham Park, NJ), and Ethocel Standard 4, an ethyl cellulose (EC) polymeric resin (Dow Chemical, Midland, MI).

**Table 5. Silver paste composition with EC resin and a hydrogenated castor oil/amide thixotrope**

| Material | Paste 7 (wt%) |
|---|---|
| EC polymeric resin | 1.14 |
| Troythix™ A (thixotropic modifying agent) | 0.66 |
| Silver particles | 82.96 |
| Lead borosilicate glass frit | 2.59 |
| Zinc oxide | 2.10 |
| SunFlo® P92-25193 dispersant | 0.25 |
| Dimethylpolysiloxane copolymer wetting agent | 0.07 |

(continued)

| Material | Paste 7 (wt%) |
|---|---|
| Texanol (solvent) | 10.23 |
| **Total** | **100.00** |

**F. Silver paste composition with rosin ester polymeric resin and a high melting-point octadecanamide wax thixotropic modifying agent**

Table 6 below sets forth the formulation of a thick film silver paste composition (Paste 8) that contained Crayvallac Super®, a high melting-point (120-130°C) octadecanamide wax thixotropic modifying agent (Cray Valley, Exton, PA), and Foralyn 90, a glycerol ester of hydrogenated rosin polymeric resin (Eastman Chemical, Kingsport, TN).

**Table 6. Silver paste composition with EC polymeric resin and a hydrogenated castor oil/amide thixotrope.**

| Material | Paste 8 (wt%) |
|---|---|
| Rosin ester polymeric resin | 0.90 |
| Crayvallac Super® (thixotropic modifying agent) | 1.10 |
| Silver particles | 81.94 |
| Lead borosilicate glass frit | 2.52 |
| Zinc oxide | 5.49 |
| SunFlo® P92-25193 dispersant | 0.25 |
| Dimethylpolysiloxane copolymer wetting agent | 0.06 |
| Texanol (solvent) | 7.74 |
| **Total** | **100.00** |

**Example 2**

**Properties of silver paste compositions**

**A. Rheological properties**

The viscosities of Pastes 1-3 and 8 were measured at shear rates of 1 $s^{-1}$ and 10 $s^{-1}$ using an AR2000ex viscometer (TA Instruments, Newcastle, DE) having a parallel plate setup with a serrated bottom plate. The shear thinning index (STI), the ratio of the viscosity measured at 1 $s^{-1}$ to the viscosity measured at 10 $s^{-1}$, was also calculated. The STI indicates shear-thinning behavior, where viscosity is high when the paste is at rest and is low when the paste is under shear. For fine printed grid lines with high aspect ratios, a paste must exhibit shear-thinning behavior, i.e., have low viscosity in order to squeeze through a screen mesh, but a high viscosity to avoid spreading of the printed line. The results are shown below in Table 7.

The thixotropic, or stress, recovery time is the time a paste composition requires to return to the resting viscosity after experiencing high shear rate agitation. The faster the recovery time, the less slump a paste will exhibit. Slumping occurs when the printed line loses height and gains width, starting just after the printing screen is released. Due to slumping, the printed line width can be 1.5 times (or more) the line width in the screen.

**Table 7. Viscosities and STI values of Pastes 1-3 and 8.**

| Paste | Viscosity at 1 $s^{-1}$ (Pa*s) | Viscosity at 10 $s^{-1}$ (Pa*s) | STI value |
|---|---|---|---|
| **1** | 1092.8 | 117 | 9.34 |
| **2** | 912 | 80 | 11.4 |
| **3** | 1203.5 | 145 | 8.3 |
| **4** | 1554 | 335.2 | 4.6 |

(continued)

| Paste | Viscosity at 1 $s^{-1}$ (Pa*s) | Viscosity at 10 $s^{-1}$ (Pa*s) | STI value |
|---|---|---|---|
| **5** | 2023 | 380.1 | 5.3 |
| **6** | 2056 | 366.9 | 5.6 |
| **7** | 1450 | 239 | 6.1 |
| **8** | 2166 | 190 | 11.4 |

The recovery time of the paste compositions was determined by a rheology test, the shear jump experiment. The experiment was conducted by first applying a high shear rate to the paste composition sample, followed by a low shear rate, while recording shear stress. During the low shear segment of the test, a thixotropic material will start with a low shear stress and gradually recover to an equilibrium value. Paste compositions 1-3 and 8 were tested twice for 3 minutes at a high shear rate of 2 $s^{-1}$. The recovery value was calculated as a percentage of plateau viscosity at 0.1 s-1 after being subjected to the high shear stress. The recovery value is the amount of time taken for the paste compositions to recover viscosity to 90% of the plateau value. The shear stress recovery values of Pastes 1-3 and 8 are shown below in Table 8 and in Figure 1.

**Table 8. Recovery time of Pastes 1-3 and 8.**

| Paste | Recovery time (s) |
|---|---|
| **1** | 3-5 |
| **2** | 4 |
| **3** | >70 |
| **8** | <1 |

Silicon solar cells were screen printed with silver paste compositions 1-3 and 8 using industry-standard screens (325 mesh, 60-100 micron line openings, 10-25 micron emulsion).

Paste 1 included a high melting point wax thixotropic modifying agent (CRAYVALLAC Super®, which includes octadecanamide wax as a primary component) but did not include any polymeric resin. Paste 1 exhibited fast thixotropic recovery, which minimized the slumping of the grid lines after printing and could be screen printed. The lack of resin, however, created difficulties in dispersing the particulate components during manufacture and resulted in printing problems, such as broken lines.

Pastes 2 and 8, also containing CRAYVALLAC Super® as a high melting point wax thixotropic modifying agent, included an ethyl cellulose resin. Pastes 2 and 8 also exhibited fast thixotropic recovery, which minimized the slumping of the grid lines after printing. The printed features using Pastes 2 and 8 exhibited printed line widths no more than 10% greater than the nominal screen opening and the printed lines had aspect ratios (line height/line width) exceeding 0.4, as shown in Figures 2A and 2B. These pastes printed with reduced defects, such as no broken lines, and there was no difficulty in dispersing the particulate components during manufacture.

Paste 3, which contained CRAYVALLAC Super® as a high melting point wax thixotropic modifying agent and also contained an ethyl cellulose resin, exhibited a poor recovery time, which led to the production of printed lines more than 50% wider than the nominal screen opening, with an aspect ratio (height/width) of less than 0.2, as shown in Figures 3A and 3B. The amount of thixotropic agent was believed to be too low for the amount of resin, resulting in a paste with a low STI and long recovery time, leading to line slumping and increased grid line width. Increasing the amount of high melting point wax thixotropic modifying agent in the paste (from 0.4 wt% to 0.67 wt%), while decreasing the amount of ethyl cellulose resin (from 0.45 wt% to 0.04 wt%) increased the STI significantly and exhibited fast thixotropic recovery, which minimized the slumping of the grid lines after printing.

## Elastic moduli

The elastic modulus of a paste represents its ability to return to its original viscosity after stress is applied and is represented by a ratio of stress to strain. The results of elastic modulus measurements as a function of temperature are shown in Figure 4. The results demonstrate that the paste retains its viscosity (as evidenced by retention of elastic modulus at temperature) at least up to the thixotrope agent melting point. Paste 4, which contains CRAYVALLAC Super ® as a high melting point wax thixotropic modifying agent, maintains high elastic moduli at higher temperature than

pastes based on other thixotropic modifying agents (Pastes 5-7), which leads to faster recovery time and reduced line spreading of a printed feature.

**B. Solar cell performance properties**

Photovoltaic (PV) cell testing was conducted in order to determine the quality and efficiency of the thick film paste compositions when used for front side metallization of solar cells. The solar cell I-V curves were measured and performance parameters determined by a Solar Cell I-V Tester Model IV16 (PV Measurements, Inc., Boulder, CO) using a continuous beam.

Pastes 2 and 8 were tested in the I-V Tester. Each silver paste composition achieved a fill factor of greater than 70% and efficiencies over 15.5% on a 5 inch monocrystalline wafer. The fill factor is the ratio of the actual maximum obtainable power to the product of the open circuit voltage and short circuit current. Pastes 2 and 8 are comparable to typical commercial solar cells in that there were able to achieve a fill factor of greater than 70%. Pastes 2 and 8 are preferred pastes for front side metallization of solar cells.

## Claims

**1.** A metallic paste, comprising:

greater than 50% by weight electrically conductive metal particles;
an amide-based wax having a melting point greater than 110°C;
glass frit;
a solvent; and
a resin;
wherein:
the metallic paste has a viscosity of 50 to 250 Pa·s at 10 $sec^{-1}$ at 25°C and a shear-thinning index of at least 10 or a recovery time less than 10 seconds or both.

**2.** The paste of claim 1, wherein the electrically conductive metal particles contain a metal selected from among silver, gold, copper, aluminum, nickel, palladium, cobalt, chromium, platinum, tantalum indium, tungsten, tin, zinc, lead, chromium, ruthenium, tungsten, iron, rhodium, iridium and osmium and combinations or alloys thereof.

**3.** The paste of claim 1 or 2, wherein the electrically conductive metal particles contain silver or a silver alloy.

**4.** The paste of any one of claims 1 to 3, wherein the electrically conductive metal particles have:

a shape selected from among cubes, flakes, granules, cylinders, rings, rods,
needles, prisms, disks, fibers, pyramids, spheres, spheroids, prolate spheroids, oblate spheroids, ellipsoids, ovoids and random non-geometric shapes; and
a particle size between 1 nm to 10 μm.

**5.** The paste of claims 1 to 3, wherein the electrically conductive metal particles have a $D_{50}$ of 2.5 microns or less.

**6.** The paste of any one of claims 1 to 5, wherein the amide-based wax contains a primary, secondary or tertiary fatty amides or a fatty bis-amide.

**7.** The paste of any one of claims 1 to 6, wherein the glass frit contains a bismuth-based glass, a lead borosilicate-based glass or a lead-free glass or a combination thereof.

**8.** The paste of any one of claims 1 to 7, wherein the glass frit is present in an amount from 0.1 wt% to 10 wt% based on the weight of the paste composition.

**9.** The paste of any one of claims 1 to 8, wherein the solvent is selected from among acetophenone, benzyl alcohol, 2-butoxyethanol, 3-butoxy-butanol, butyl carbitol, γ-butyrolactone, 1,2-dibutoxyethane, diethylene glycol monobutyl ether, dimethyl glutarate, dibasic ester mixture of dimethyl glutarate and dimethyl succinate, dipropylene glycol, dipropylene glycol monoethyl ether acetate, dipropylene glycol *n*-butyl ether, 2-(2-ethoxyethoxy) ethyl acetate, ethylene glycol, 2,4-heptanediol, hexylene glycol, methyl carbitol, N-methyl-pyrrolidone, 2,2,4-trimethyl-1,3-pentanediol

di-isobutyrate (TX1B), 2,2,4-trimethyl-1,3-pentanediol monoisobutyrate (texanol), phenoxy ethanol, 1-phenoxy-2-propanol, phenyl carbitol, propylene glycol phenyl ether, terpineol, tetradecane, glycerol and tripropylene glycol n-butyl ether and mixtures of these solvents.

**10.** The paste of any one of claims 1 to 9, wherein the solvent is present in an amount from 2 wt% to 15 wt% based on the weight of the paste composition.

**11.** The paste of claim any one of claims 1 to 10, wherein the resin is selected from among an ethyl cellulose resin, a glycerol ester of hydrogenated rosin, an acrylic binder and combinations thereof.

**12.** The paste of any one of claims 1 to 11, wherein the resin is present in an amount from 0.01 wt% to 5 wt% based on the weight of the paste composition.

**13.** The paste of any one of claims 1 to 12, further comprising a dispersant in an amount from 0.1 wt% to 5 wt% based on the weight of the paste composition.

**14.** The paste of claim 13, wherein the dispersant is a polymeric dispersant of the structure:

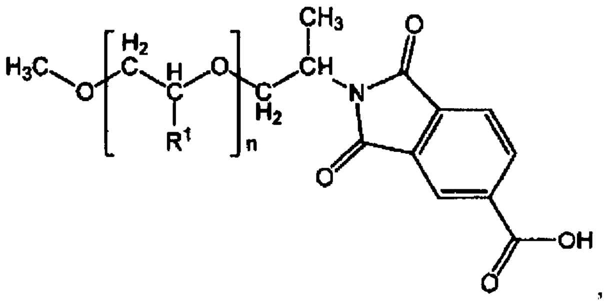

,

wherein $R^1$ is H or $CH_3$ and n is an integer from 4 to 200.

**15.** Use of a metallic paste according to any of claims 1 to 14 for forming an electrode on a substrate.

**16.** Use according to claim 15 wherein the substrate is a semiconductor device or a photovoltaic device.

**17.** Use of a metallic paste according to any of claims 1 to 14 for forming a solar cell.

## Patentansprüche

**1.** Metallische Paste, umfassend:

mehr als 50 Gew.-% elektrisch leitfähige Metallteilchen;
ein Wachs auf Amid-Basis mit einem Schmelzpunkt von höher als 110°C;
Glasfritte;
ein Lösungsmittel; und
ein Harz;
wobei:

die metallische Paste eine Viskosität von 50 bis 250 Pa·s bei 10 $sec^{-1}$ bei 25°C und einen Strukturviskositätsindex von mindestens 10 oder eine Erholungszeit von kürzer als 10 Sekunden oder beides aufweist.

**2.** Paste nach Anspruch 1, wobei die elektrisch leitfähigen Metallteilchen ein Metall, ausgewählt aus Silber, Gold, Kupfer, Aluminium, Nickel, Palladium, Cobalt, Chrom, Platin, Tantal, Indium, Wolfram, Zinn, Zink, Blei, Chrom, Ruthenium, Wolfram, Eisen, Rhodium, Iridium und Osmium und Kombinationen oder Legierungen davon, enthalten.

**3.** Paste nach Anspruch 1 oder 2, wobei die elektrisch leitfähigen Metallteilchen Silber oder eine Silberlegierung enthalten.

4. Paste nach einem der Ansprüche 1 bis 3, wobei die elektrisch leitfähigen Metallteilchen aufweisen:

   eine Form, ausgewählt aus Würfeln, Flocken, Granula, Zylindern, Ringen, Stäbchen, Nadeln, Prismen, Scheiben, Fasern, Pyramiden, Kugeln, Sphäroiden, gestreckten Sphäroiden, abgeplatteten Sphäroiden, Ellipsoiden, Ovoiden und statistischen nichtgeometrischen Formen; und
   eine Teilchengröße von zwischen 1 nm bis 10 $\mu$m.

5. Paste nach den Ansprüchen 1 bis 3, wobei die elektrisch leitfähigen Metallteilchen einen $D_{50}$-Wert von 2,5 Mikron oder niedriger aufweisen.

6. Paste nach einem der Ansprüche 1 bis 5, wobei das Wachs auf Amid-Basis ein primäres, sekundäres oder tertiäres Fett-Amid oder ein Fett-Bisamid enthält.

7. Paste nach einem der Ansprüche 1 bis 6, wobei die Glasfritte ein Glas auf Bismut-Basis, ein Glas auf Bleiborsilikat-Basis oder ein bleifreies Glas oder eine Kombination davon enthält.

8. Paste nach einem der Ansprüche 1 bis 7, wobei die Glasfritte in einer Menge von 0,1 Gew.-% bis 10 Gew.-%, bezogen auf das Gewicht der Pastenzusammensetzung, vorhanden ist.

9. Paste nach einem der Ansprüche 1 bis 8, wobei das Lösungsmittel aus Acetophenon, Benzylalkohol, 2-Butoxyethanol, 3-Butoxybutanol, Butylcarbitol, $\gamma$-Butyrolacton, 1,2-Dibutoxyethan, Diethylenglycolmonobutylether, Dimethylglutarat, zweibasischem Estergemisch von Dimethylglutarat und Dimethylsuccinat, Dipropylenglycol, Dipropylenglycolmonoethyletheracetat, Dipropylenglycol-*n*-butylether, 2-(2-Ethoxyethoxy)ethylacetat, Ethylenglycol, 2,4-Heptandiol, Hexylenglycol, Methylcarbitol, N-Methylpyrrolidon, 2,2,4-Trimethyl-1,3-pentandioldiisobutyrat (TXIB), 2,2,4-Trimethyl-1,3-pentandiolmonoisobutyrat (Texanol), Phenoxyethanol, 1-Phenoxy-2-propanol, Phenylcarbitol, Propylenglycolphenylether, Terpineol, Tetradecan, Glycerol und Tripropylenglycol-*n*-butylether und Gemischen von diesen Lösungsmitteln ausgewählt ist.

10. Paste nach einem der Ansprüche 1 bis 9, wobei das Lösungsmittel in einer Menge von 2 Gew.-% bis 15 Gew.-%, bezogen auf das Gewicht der Pastenzusammensetzung, vorhanden ist.

11. Paste nach einem der Ansprüche 1 bis 10, wobei das Harz aus Ethylcellulose-Harz, einem Glycerolester von hydriertem Kolophonium, einem Acryl-Bindemittel und Kombinationen davon ausgewählt ist.

12. Paste nach einem der Ansprüche 1 bis 11, wobei das Harz in einer Menge von 0,01 Gew.-% bis 5 Gew.-%, bezogen auf das Gewicht der Pastenzusammensctzung, vorhanden ist.

13. Paste nach einem der Ansprüche 1 bis 12, ferner umfassend ein Dispersantmittel in einer Menge von 0,1 Gew.-% bis 5 Gew.-%, bezogen auf das Gewicht der Pastenzusammensetzung.

14. Paste nach Anspruch 13, wobei das Dispersantmittel ein polymeres Dispersantmittel mit der folgenden Struktur ist:

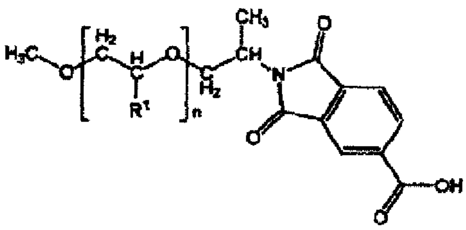

,

wobei $R^1$ H oder $CH_3$ ist und n eine ganze Zahl von 4 bis 200 ist.

15. Verwendung einer metallischen Paste gemäß einem der Ansprüche 1 bis 14 zur Bildung einer Elektrode auf einem Substrat.

16. Verwendung gemäß Anspruch 15, wobei das Substrat eine Halbleitervorrichtung oder eine Photovoltaikvorrichtung ist.

**17.** Verwendung einer metallischen Paste gemäß einem der Ansprüche 1 bis 14 zur Bildung einer Solarzelle.

**Revendications**

**1.** Pâte métallique comprenant :

plus de 50 % en poids de particules métalliques électriquement conductrices ;
une cire à base d'amide ayant un point de fusion supérieur à 110°C ;
une fritte de verre ;
un solvant ; et
une résine ;
dans laquelle :

la pâte métallique a une viscosité de 50 à 250 Pa.s à 10 $s^{-1}$ à 25°C et un indice de fluidification par cisaillement d'au moins 10 ou un temps de récupération inférieur à 10 secondes ou les deux.

**2.** Pâte selon la revendication 1, dans laquelle les particules métalliques électriquement conductrices contiennent un métal choisi parmi l'argent, l'or, le cuivre, l'aluminium, le nickel, le palladium, le cobalt, le chrome, le platine, le tantale, l'indium, le tungstène, l'étain, le zinc, le plomb, le chrome, le ruthénium, le tungstène, le fer, le rhodium, l'iridium et l'osmium, ainsi que leurs combinaisons et alliages.

**3.** Pâte selon la revendication 1 ou 2, dans laquelle les particules métalliques électriquement conductrices contiennent de l'argent ou un alliage d'argent.

**4.** Pâte selon l'une quelconque des revendications 1 à 3, dans laquelle les particules métalliques électriquement conductrices ont :

une forme choisie parmi les cubes, les copeaux, les granules, les cylindres, les anneaux, les barres, les aiguilles, les prismes, les disques, les fibres, les pyramides, les sphères, les sphéroïdes, les sphéroïdes allongés, les sphéroïdes aplatis, les ellipsoïdes, les ovoïdes et les formes aléatoires non géométriques ; et
une granulométrie comprise entre 1 nm et 10 $\mu$m.

**5.** Pâte selon les revendications 1 à 3, dans laquelle les particules métalliques électriquement conductrices ont une $D_{50}$ de 2,5 micromètres ou moins.

**6.** Pâte selon l'une quelconque des revendications 1 à 5, dans laquelle la cire à base d'amide contient un amide gras primaire, secondaire ou tertiaire ou un bis-amide gras.

**7.** Pâte selon l'une quelconque des revendications 1 à 6, dans laquelle la fritte de verre contient un verre à base de bismuth, un verre à base de borosilicate de plomb ou un verre sans plomb, ou une combinaison de ceux-ci.

**8.** Pâte selon l'une quelconque des revendications 1 à 7, dans laquelle la fritte de verre est présente en une quantité de 0,1 % en poids à 10 % en poids par rapport au poids de la composition de pâte.

**9.** Pâte selon l'une quelconque des revendications 1 à 8, dans laquelle le solvant est choisi parmi l'acétophénone, l'alcool benzylique, le 2-butoxyéthanol, le 3-butoxyéthanol, le butylcarbitol, la ▪ -butyrolactone, le 1,2-dibutoxyéthane, l'éther monobutylique de diéthylèneglycol, le glutarate de diméthyle, un mélange d'esters dibasiques de glutarate de diméthyle et de succinate de diméthyle, le dipropylèneglycol, l'acétate d'éther monoéthylique de dipropylèneglycol, l'éther n-butylique de dipropylèneglycol, l'acétate de 2-(2-éthoxyéthoxy)éthyle, l'éthylèneglycol, le 2,4-heptanediol, l'hexylèneglycol, le méthylcarbitol, la N-méthylpyrrolidone, le diisobutyrate de 2,2,4-triméthyl-1,3-pentanediol (TXIB), le monoisobutyrate de 2,2,4-triméthyl-1,3-pentanediol (texanol), le phénoxyéthanol, le 1-phénoxy-2-propanol, le phénylcarbitol, l'éther phénylique de propylèneglycol, le terpinéol, le tétradécane, le glycérol et l'éther n-butylique de tripropylèneglycol, ainsi que les mélanges de ces solvants.

**10.** Pâte selon l'une quelconque des revendications 1 à 9, dans laquelle le solvant est présent en une quantité de 2 % en poids à 15 % en poids par rapport au poids de la composition de pâte.

**11.** Pâte selon l'une quelconque des revendications 1 à 10, dans laquelle la résine est choisie parmi une résine d'éthylcellulose, un ester de glycérol de colophane hydrogénée, un liant acrylique, et leurs mélanges.

**12.** Pâte selon l'une quelconque des revendications 1 à 11, dans laquelle la résine est présente en une quantité de 0,01 % en poids à 5 % en poids par rapport au poids de la composition de pâte.

**13.** Pâte selon l'une quelconque des revendications 1 à 12, comprenant en outre un dispersant en une quantité de 0,1 % en poids à 5 % en poids par rapport au poids de la composition de pâte.

**14.** Pâte selon la revendication 13, dans laquelle le dispersant est un dispersant polymère de structure :

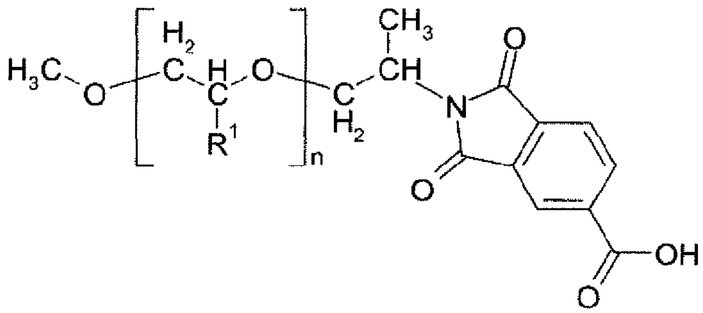

dans laquelle $R^1$ est H ou $CH_3$ et n est un entier de 4 à 200.

**15.** Utilisation d'une pâte métallique selon l'une quelconque des revendications 1 à 14 pour former une électrode sur un substrat.

**16.** Utilisation selon la revendication 15, dans laquelle le substrat est un dispositif à semi-conducteur ou un dispositif photovoltaïque.

**17.** Utilisation d'une pâte métallique selon l'une quelconque des revendications 1 à 14 pour former une cellule solaire.

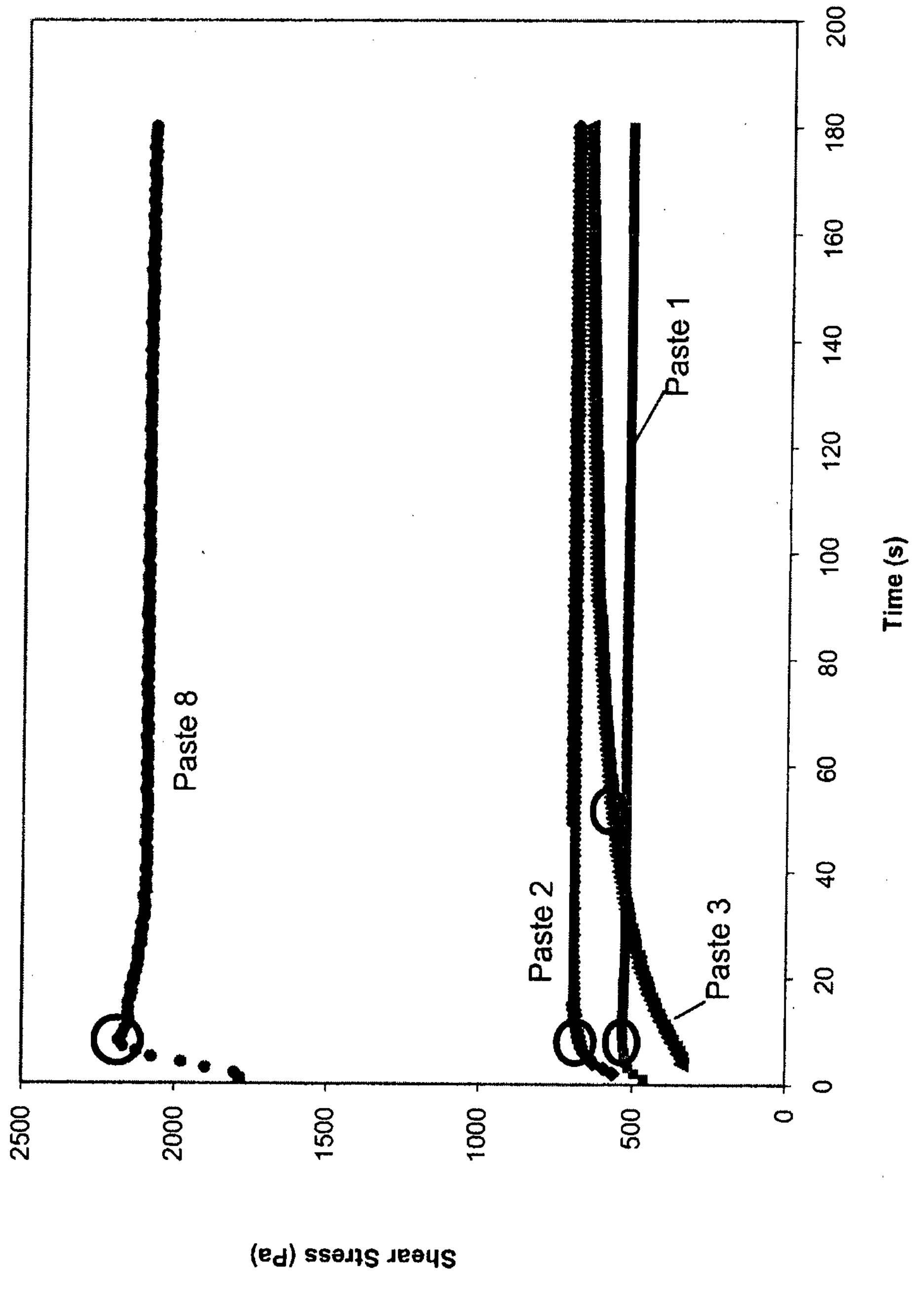
Shear Stress (Pa)
2500
2000
1500
1000
500
0
Time (s)
0
20
40
60
80
100
120
140
160
180
200
Paste 8
Paste 2
Paste 3
Paste 1

Fig. 1

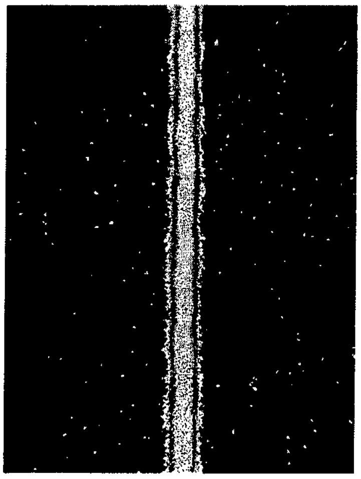

Fig. 2A

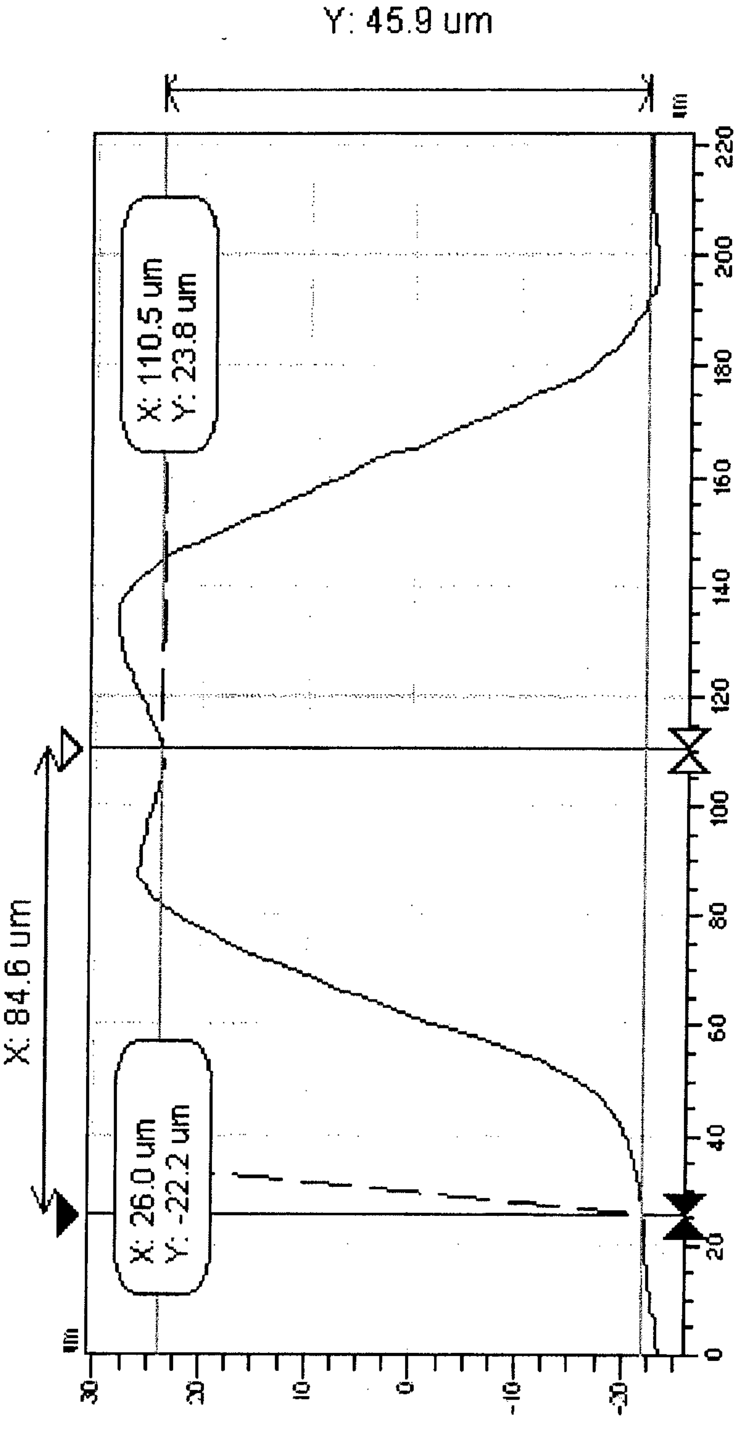
Y: 45.9 um
X: 110.5 um
Y: 23.8 um
X: 84.6 um
X: 26.0 um
Y: -22.2 um
0 20 40 60 80 100 120 140 160 180 200 220
30 20 10 0 -10 -20

Fig. 2B

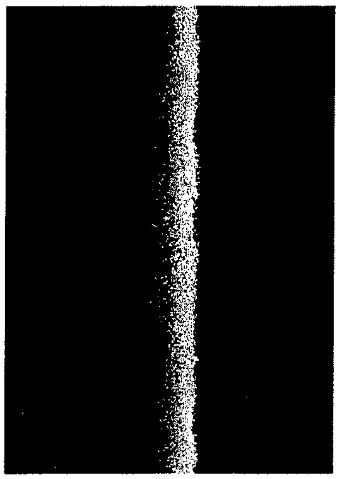

Fig. 3A

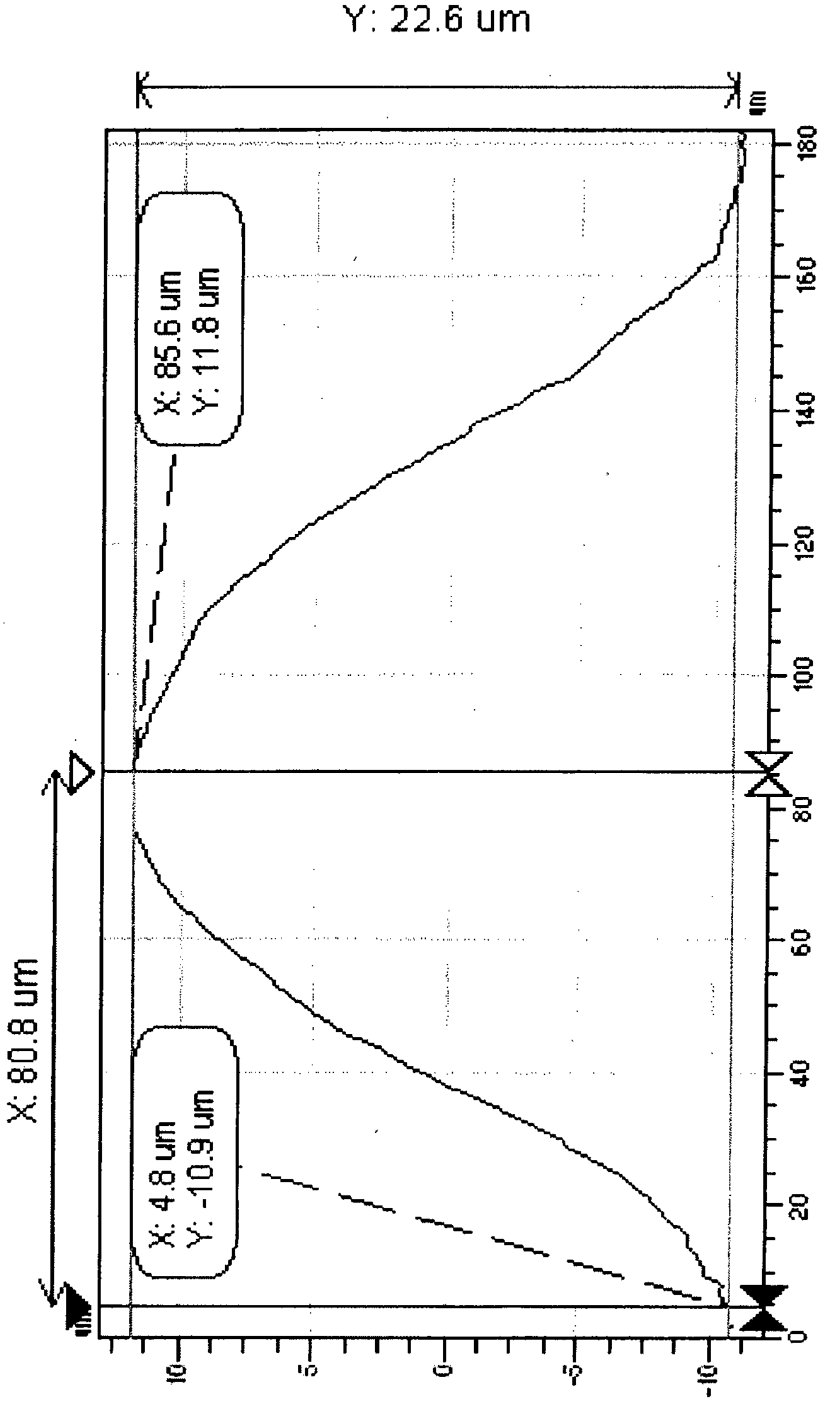
Y: 22.6 um
X: 80.8 um
X: 85.6 um
Y: 11.8 um
X: 4.8 um
Y: -10.9 um
0
20
40
60
80
100
120
140
160
180
10
5
0
-5
-10

Fig. 3B

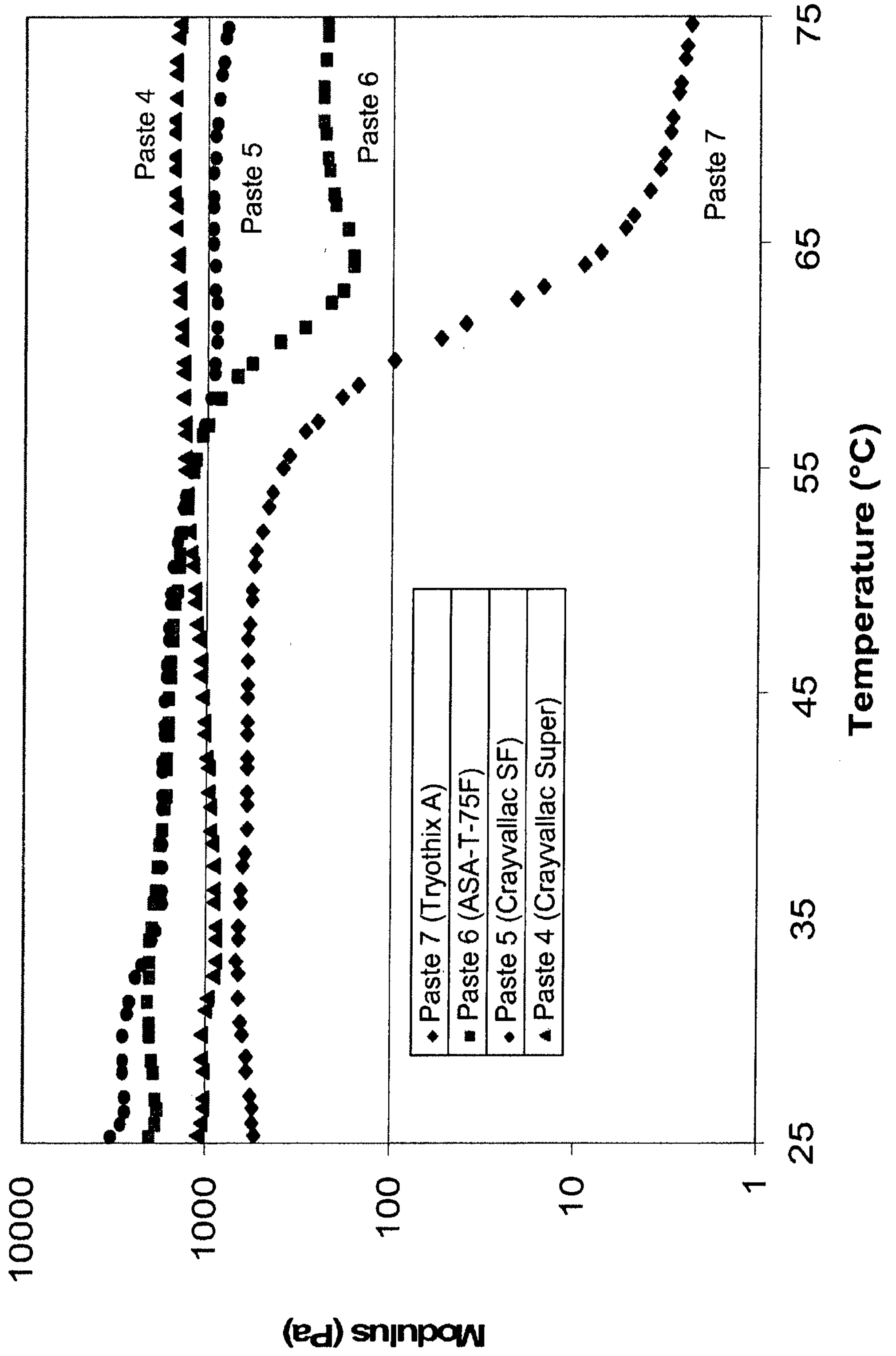
Paste 4
Paste 5
Paste 6
Paste 7
Paste 7 (Tryothix A)
Paste 6 (ASA-T-75F)
Paste 5 (Crayvallac SF)
Paste 4 (Crayvallac Super)
25
35
45
55
65
75
Temperature (°C)
10000
1000
100
10
1
Modulus (Pa)

Fig. 4

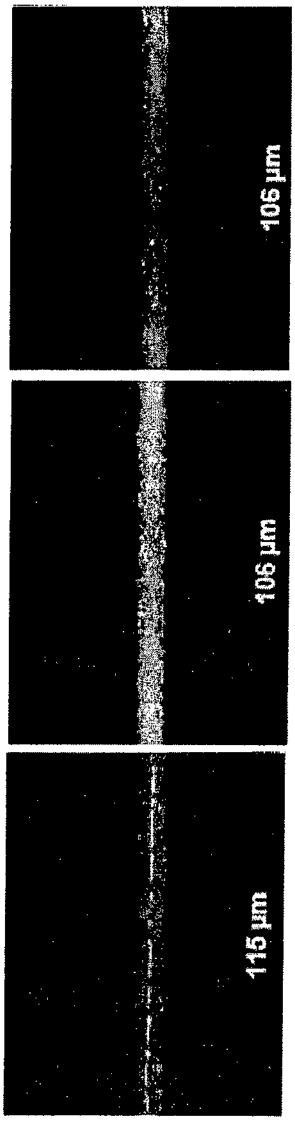


Wet Dried Fired

Fig. 5A

Wet Dried Fired

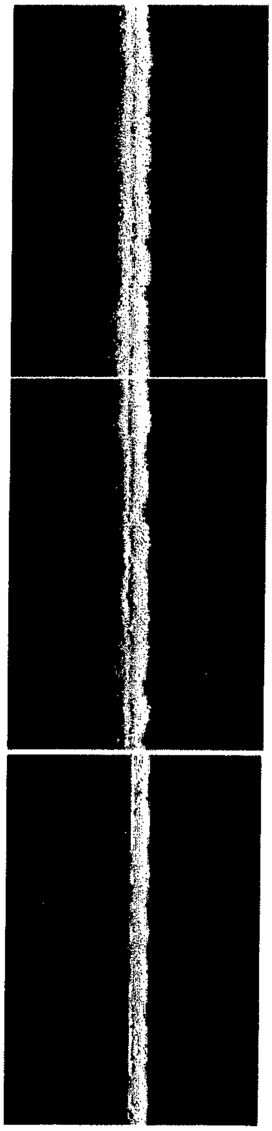

Fig. 5B

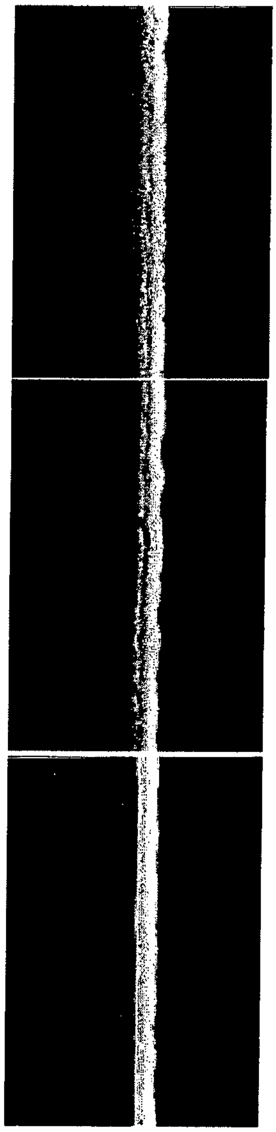

Fig. 5C

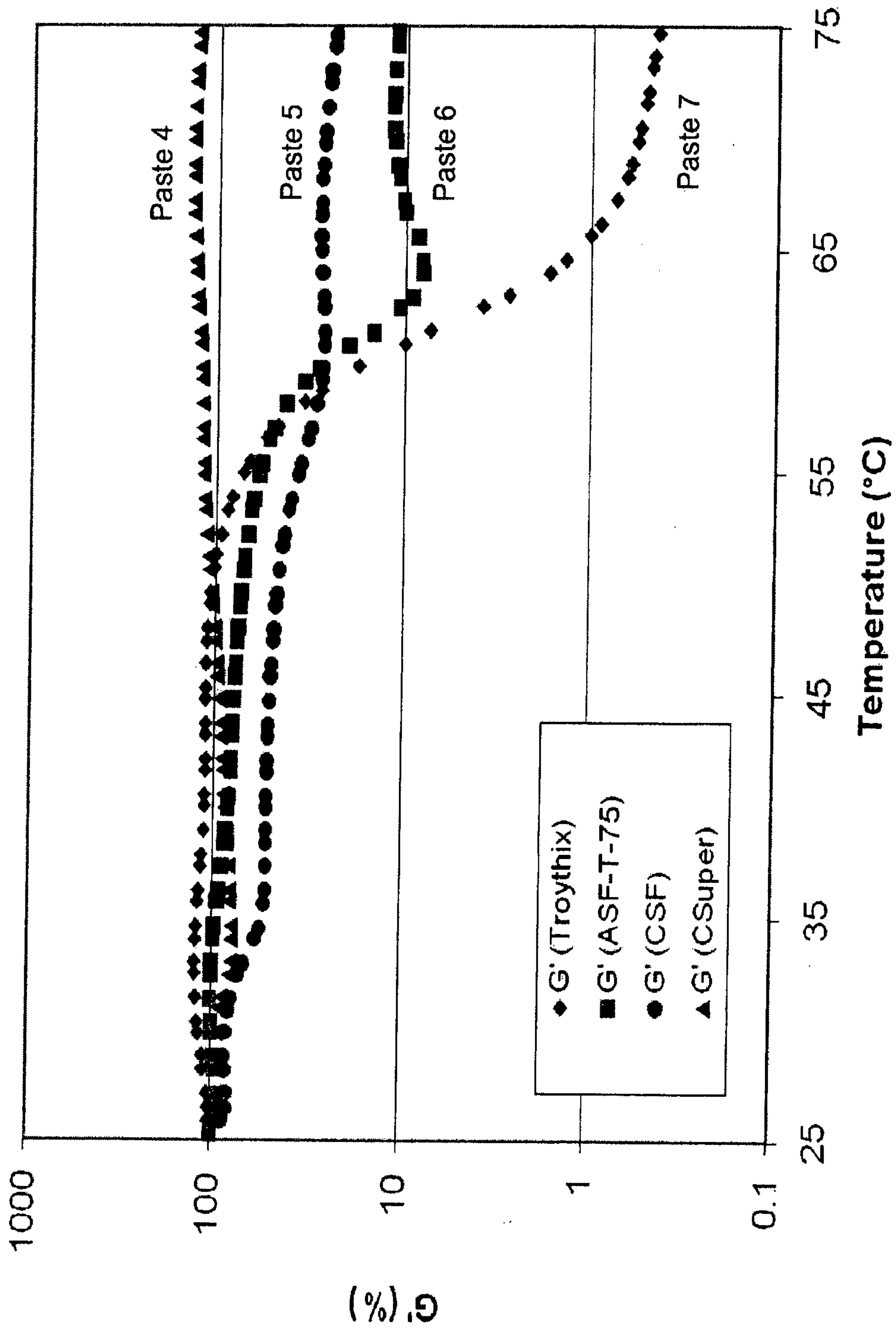
Paste 4
Paste 5
Paste 6
Paste 7
G' (Troythix)
G' (ASF-T-75)
G' (CSF)
G' (CSuper)
1000
100
10
1
0.1
G' (%)
25
35
45
55
65
75
Temperature (°C)

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2008134417 A
- US 6517931 B, Fu
- US 6982864 B, Sridharan
- US 7494607 B, Wang
- US 7504349 B, Brown
- US 20090298283 A, Akimoto
- US 20090142526 A
- US 7254197 B
- US 7265197 B
- US 20120012741 A
- US 7820097 B


### Non-patent literature cited in the description


- *ASTM D1316,* June 2011